(19) Europäisches Patentamt
European Patent Office
Office européen des brevets

(11) **EP 4 648 317 A1**

(12) **EUROPEAN PATENT APPLICATION**
published in accordance with Art. 153(4) EPC

(43) Date of publication:
**12.11.2025 Bulletin 2025/46**

(21) Application number: **23914855.4**

(22) Date of filing: **06.01.2023**

(51) International Patent Classification (IPC):
**H04L 1/00** (2006.01)   **H04W 74/08** (2024.01)
**H03M 13/39** (2006.01)   **H03M 13/43** (2006.01)

(52) Cooperative Patent Classification (CPC):
**H03M 13/39; H03M 13/43; H04L 1/00; H04W 74/08**

(86) International application number:
**PCT/KR2023/000283**

(87) International publication number:
**WO 2024/147389 (11.07.2024 Gazette 2024/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **LG Electronics Inc.**
**Yeongdeungpo-gu**
**Seoul 07336 (KR)**
• **Korea Advanced Institute of Science and Technology**
**Daejeon 34141 (KR)**

(72) Inventors:
• **KIM, Bonghoe**
**Seoul 06772 (KR)**
• **HA, Jeongseok**
**Daejeon 34033 (KR)**
• **OH, Kyungmok**
**Daejeon 34141 (KR)**

(74) Representative: **Frenkel, Matthias Alexander**
**Wuesthoff & Wuesthoff**
**Patentanwälte und Rechtsanwalt PartG mbB**
**Schweigerstraße 2**
**81541 München (DE)**

(54) **METHOD, COMMUNICATION DEVICE, PROCESSING DEVICE, AND STORAGE MEDIUM FOR PERFORMING DECODING**

(57)    This communication device may: generate P second bit sequences by cyclically shifting, on the basis of P different shift parameters, a first bit sequence obtained from a received signal; and determine a codeword by performing successive erase decoding of a list size L on each of the P second bit sequences. Each of the P different shift parameters satisfies the following. A predefined metric for a plurality of groups, which is determined on the basis of an index i of a weak bit from among N bits within the first bit sequence, is greater than a predetermined threshold value. The predefined metric is obtained by adding differences between the greatest and smallest operation values of each of the plurality of groups.

**FIG. 14**

```
┌─────────────────────────────┐
│  Select vulnerable message  │ ─ S1401
└─────────────────────────────┘
              │
┌─────────────────────────────┐
│     Analyze index group     │ ─ S1402
└─────────────────────────────┘
              │ s = 0
┌─────────────────────────────┐
│ Apply shift parameter s to  │ ─ S1403
│ channel LLR values          │
│ σ^s(L_0, L_1, ..., L_{N-1}) │
└─────────────────────────────┘
              │                        ┌─────────┐
┌─────────────────────────────┐        │ s = s+1 │
│ Calculate Min-Max Δ Sum     │ ─ S1404└─────────┘
│ metric                      │
└─────────────────────────────┘
              │
         ╱──────────╲   S1405
        ╱ Metric >    ╲ ──── No
        ╲ threshold?  ╱
         ╲──────────╱
              │ Yes
┌─────────────────────────────┐
│      Perform decoding       │ ─ S1406
└─────────────────────────────┘
```

EP 4 648 317 A1

**Description**

**TECHNICAL FIELD**

The present disclosure relates to a wireless communication system.

**BACKGROUND**

A variety of technologies, such as machine-to-machine (M2M) communication, machine type communication (MTC), and a variety of devices demanding high data throughput, such as smartphones and tablet personal computers (PCs), have emerged and spread. Accordingly, the volume of data throughput demanded to be processed in a cellular network has rapidly increased. In order to satisfy such rapidly increasing data throughput, carrier aggregation technology or cognitive radio technology for efficiently employing more frequency bands and multiple input multiple output (MIMO) technology or multi-base station (BS) cooperation technology for raising data capacity transmitted on limited frequency resources have been developed.

As more and more communication devices have required greater communication capacity, there has been a need for enhanced mobile broadband (eMBB) communication relative to legacy radio access technology (RAT). In addition, massive machine type communication (mMTC) for providing various services at anytime and anywhere by connecting a plurality of devices and objects to each other is one main issue to be considered in next-generation communication.

Communication system design considering services/user equipment (UEs) sensitive to reliability and latency is also under discussion. The introduction of next-generation RAT is being discussed in consideration of eMBB communication, mMTC, ultra-reliable and low-latency communication (URLLC), and the like.

**DISCLOSURE**

**Technical Problem**

As new radio communication technology has been introduced, the number of UEs to which a BS should provide services in a prescribed resource region is increasing and the volume of data and control information that the BS transmits/receives to/from the UEs to which the BS provides services is also increasing. Since the amount of resources available to the BS for communication with the UE(s) is limited, a new method for the BS to efficiently receive/transmit uplink/downlink data and/or uplink/downlink control information from/to the UE(s) using the limited radio resources is needed. In other words, due to increase in the density of nodes and/or the density of UEs, a method for efficiently using high-density nodes or high-density UEs for communication is needed.

Additionally, there is a need for methods of further improving the performance of polar codes proposed as an alternative to existing channel codes. For example, a list successive cancellation decoder used in polar code decoding performs a sorting operation for each bit, which results in significant implementation complexity and latency. Therefore, methods for addressing these issues are required.

The objects to be achieved with the present disclosure are not limited to what has been particularly described hereinabove and other objects not described herein will be more clearly understood by persons skilled in the art from the following detailed description.

**Technical Solution**

In an aspect of the present disclosure, provided herein is a method of decoding a received signal by a communication device in a wireless communication system.

In another aspect of the present disclosure, provided herein a communication device configured to decode a received signal in a wireless communication system. The communication device includes: at least one transceiver; at least one processor; and at least one computer memory operably connected to the at least one processor and storing instructions that, when executed, cause the at least one processor to perform operations.

In another aspect of the present disclosure, provided herein a processing device in a wireless communication system. The processing device includes: at least one processor; and at least one computer memory operably connected to the at least one processor and storing instructions that, when executed, cause the at least one processor to perform operations.

In a further aspect of the present disclosure, provided herein is a computer-readable storage medium. The computer-readable storage medium is configured to store at least one program code including instructions that, when executed, cause at least one processor to perform operations.

The method or operations may include: receiving a signal related to a first bit sequence with a length of N from another communication device, where N is an integer greater than 1; determining P different shift parameters for the first bit sequence, where P is an integer greater than 1; generating P second bit sequences by cyclically shifting the first bit sequence based on the P different shift parameters; and determining a codeword by performing successive cancellation decoding with a list size of L on each of the P second bit sequences, where L is an integer greater than 0. Determining the P different shift parameters for the first bit sequence includes determining a shift parameter s satisfying the following: an index i of a vulnerable bit among N bits of the first bit sequence is determined; operation values (e.g., channel log-likelihood ratio (LLR) values) for the first bit sequence are grouped into a plurality of groups based on the index i of the vulnerable bit; and a predefined metric (e.g., the sum of the differences between the minimum and maximum values) for the plurality of groups exceeds a predetermined threshold, wherein the predefined metric is obtained by summing differences between largest and smallest operation values for each of the plurality of groups. In each aspect of the present disclosure, grouping the operation values into the plurality of groups based on the index i of the vulnerable bit may include: based on a binary representation of the index i of the vulnerable bit, $(b\_1, b\_2, ..., b\_(n-1))$, determining to apply a boxplus operation for $b\_j = 0$ and to apply a summation operation for $b\_j = 0$; and determining indices of operation values combined by the boxplus operation among the operation values as one group.

In each aspect of the present disclosure, the first bit sequence may include bits obtained by the other communication device by encoding information bits with a length of K with an error correction code with a size of N.

In each aspect of the present disclosure, the method or operations may include: determining combinations of candidates for a number of permutation paths and candidate list sizes based on a fixed complexity for a parallelism of N/2; and determining a combination with optimal performance based on decoding performance of each of the combinations. A candidate for the number of permutation paths and a candidate list size of the combination with the optimal performance may be used as P and L, respectively.

The foregoing solutions are merely a part of the examples of the present disclosure and various examples into which the technical features of the present disclosure are incorporated may be derived and understood by persons skilled in the art from the following detailed description.

## Advantageous Effects

According to some implementation(s) of the present disclosure, a wireless communication signal may be efficiently transmitted/received. Accordingly, the total throughput of a wireless communication system may be raised.

According to some implementations of the present disclosure, parallel decoding for polar codes may become feasible. Accordingly, the disadvantages of a conventional polar code decoding method, where the complexity increases due to metric sorting, may be overcome.

The effects according to the present disclosure are not limited to what has been particularly described hereinabove and other effects not described herein will be more clearly understood by persons skilled in the art related to the present disclosure from the following detailed description.

## BRIEF DESCRIPTION OF THE DRAWINGS

The accompanying drawings, which are included to provide a further understanding of the present disclosure, illustrate examples of implementations of the present disclosure and together with the detailed description serve to explain implementations of the present disclosure:

FIG. 1 illustrates an example of a communication system 1 to which implementations of the present disclosure are applied;

FIG. 2 is a block diagram illustrating examples of communication devices capable of performing a method according to the present disclosure;

FIG. 3 illustrates another example of a wireless device capable of performing implementation(s) of the present disclosure;

FIG. 4 illustrates an example of a frame structure used in a 3rd generation partnership project (3GPP)-based wireless communication system;

FIG. 5 illustrates a process for processing a transport block (TB) on a transmitting side;

FIG. 6 is an exemplary block diagram for a polar encoder;

FIG. 7 illustrates the concept of channel splitting and channel combining for channel polarization;

FIG. 8 illustrates N-th level channel combining for polar codes;

FIG. 9 illustrates evolution of decoding paths in a list-L decoding process;

FIG. 10 is a diagram to explain the concept of selecting position(s) to which information bit(s) are to be allocated in polar codes;

FIG. 11 illustrates puncturing and information bit allocation for polar codes;

FIG. 12 illustrates an example of a permutation decoder;

FIG. 13 illustrates correlation between decoding success or failure and a metric based on permutation (shift) parameters;

FIG. 14 illustrates a decoding process according to some implementations of the present disclosure;

FIG. 15 is a diagram for explaining a process of partitioning channels according to some implementations of the present disclosure;

FIG. 16 illustrates the success or failure of decoding based on the sum of minimum-maximum differences of log-likelihood ratio (LLR) groups according to permutation (shift) parameters;

FIG. 17 illustrates a comparison of the performance of a decoding method that selects a shift parameter according to some implementations of the present disclosure with other decoding methods;

FIG. 18 illustrates a comparison of the performance between a decoding method that selects a shift parameter according to some implementations of the present disclosure and a successive cancellation list (SCL) decoding method;

FIG. 19 illustrates another example of a permutation decoder;

FIG. 20 illustrates the performance of permutation-based SCL decoding depending on the number of permutation paths and list sizes;

FIG. 21 illustrates required areas for a sorter and SCL decoder depending on list sizes;

FIG. 22 illustrates a comparison of normalized word error ratio (WER) performance based on a fixed computational complexity;

FIG. 23 illustrates physical channels used in a 3GPP-based communication system, which is an example of a wireless communication system, and a signal transmission/reception process using the same; and

FIG. 24 illustrates a random access procedure applicable to implementation(s) of the present disclosure.

## DETAILED DESCRIPTION

Hereinafter, implementations according to the present disclosure will be described in detail with reference to the accompanying drawings. The detailed description, which will be given below with reference to the accompanying drawings, is intended to explain exemplary implementations of the present disclosure, rather than to show the only implementations that may be implemented according to the present disclosure. The following detailed description includes specific details in order to provide a thorough understanding of the present disclosure. However, it will be apparent to those skilled in the art that the present disclosure may be practiced without such specific details.

In some instances, known structures and devices may be omitted or may be shown in block diagram form, focusing on important features of the structures and devices, so as not to obscure the concept of the present disclosure. The same reference numbers will be used throughout the present disclosure to refer to the same or like parts.

A technique, a device, and a system described below may be applied to a variety of wireless multiple access systems. The multiple access systems may include, for example, a code division multiple access (CDMA) system, a frequency division multiple access (FDMA) system, a time division multiple access (TDMA) system, an orthogonal frequency division multiple access (OFDMA) system, a single-carrier frequency division multiple access (SC-FDMA) system, a multi-carrier frequency division multiple access (MC-FDMA) system, etc. CDMA may be implemented by radio technology such as universal terrestrial radio access (UTRA) or CDMA2000. TDMA may be implemented by radio technology such as global system for mobile communications (GSM), general packet radio service (GPRS), enhanced data rates for GSM evolution (EDGE) (i.e., GERAN), etc. OFDMA may be implemented by radio technology such as institute of electrical and electronics engineers (IEEE) 802.11 (Wi-Fi), IEEE 802.16 (WiMAX), IEEE 802.20, evolved-UTRA (E-UTRA), etc. UTRA is part of universal mobile telecommunications system (UMTS) and 3rd generation partnership project (3GPP) long-term evolution (LTE) is part of E-UMTS using E-UTRA. 3GPP LTE adopts OFDMA on downlink (DL) and adopts SC-FDMA on uplink (UL). LTE-advanced (LTE-A) is an evolved version of 3GPP LTE.

For convenience of description, description will be given under the assumption that the present disclosure is applied to LTE and/or new RAT (NR). However, the technical features of the present disclosure are not limited thereto. For example, although the following detailed description is given based on mobile communication systems corresponding to 3GPP LTE/NR systems, the mobile communication systems are applicable to other arbitrary mobile communication systems except for matters that are specific to the 3GPP LTE/NR system.

For terms and techniques that are not described in detail among terms and techniques used in the present disclosure, reference may be made to 3GPP based standard specifications, for example, 3GPP TS 36.211, 3GPP TS 36.212, 3GPP TS 36.213, 3GPP TS 36.321, 3GPP TS 36.300, 3GPP TS 36.331, 3GPP TS 37.213, 3GPP TS 38.211, 3GPP TS 38.212, 3GPP TS 38.213, 3GPP TS 38.214, 3GPP TS 38.300, 3GPP TS 38.331, etc.

In examples of the present disclosure described later, if a device "assumes" something, this may mean that a channel transmission entity transmits a channel in compliance with the corresponding "assumption." This also may mean that a channel reception entity receives or decodes the channel in the form of conforming to the "assumption" on the premise that the channel has been transmitted in compliance with the "assumption."

In the present disclosure, a user equipment (UE) may be fixed or mobile. Each of various devices that transmit and/or receive user data and/or control information by communicating with a base station (BS) may be the UE. The term UE may be referred to as terminal equipment, mobile station (MS), mobile terminal (MT), user terminal (UT), subscriber station (SS), wireless device, personal digital assistant (PDA), wireless modem, handheld device, etc. In the present disclosure, a BS refers to a fixed station that communicates with a UE and/or another BS and exchanges data and control information with a UE and another BS. The term BS may be referred to as advanced base station (ABS), Node-B (NB), evolved Node-B (eNB), base transceiver system (BTS), access point (AP), processing server (PS), etc. Particularly, a BS of a universal terrestrial radio access (UTRAN) is referred to as an NB, a BS of an evolved-UTRAN (E-UTRAN) is referred to as an eNB, and a BS of new radio access technology network is referred to as a gNB. Hereinbelow, for convenience of description, the NB, eNB, or gNB will be referred to as a BS regardless of the type or version of communication technology.

In the present disclosure, a node refers to a fixed point capable of transmitting/receiving a radio signal to/from a UE by communication with the UE. Various types of BSs may be used as nodes regardless of the names thereof. For example, a BS, NB, eNB, pico-cell eNB (PeNB), home eNB (HeNB), relay, repeater, etc. may be a node. Furthermore, a node may not be a BS. For example, a radio remote head (RRH) or a radio remote unit (RRU) may be a node. Generally, the RRH and RRU have power levels lower than that of the BS. Since the RRH or RRU (hereinafter, RRH/RRU) is connected to the BS through a dedicated line such as an optical cable in general, cooperative communication according to the RRH/RRU and the BS may be smoothly performed relative to cooperative communication according to BSs connected through a wireless link. At least one antenna is installed per node. An antenna may refer to a physical antenna port or refer to a virtual antenna or an antenna group. The node may also be called a point.

In the present disclosure, a cell refers to a specific geographical area in which one or more nodes provide communication services. Accordingly, in the present disclosure, communication with a specific cell may mean communication with a BS or a node providing communication services to the specific cell. A DL/UL signal of the specific cell refers to a DL/UL signal from/to the BS or the node providing communication services to the specific cell. A cell providing UL/DL communication services to a UE is especially called a serving cell. Furthermore, channel status/quality of the specific cell refers to channel status/quality of a channel or a communication link generated between the BS or the node providing communication services to the specific cell and the UE. In 3GPP-based communication systems, the UE may measure a DL channel state from a specific node using cell-specific reference signal(s) (CRS(s)) transmitted on a CRS resource and/or channel state information reference signal(s) (CSI-RS(s)) transmitted on a CSI-RS resource, allocated to the specific node by antenna port(s) of the specific node.

A 3GPP-based communication system uses the concept of a cell in order to manage radio resources, and a cell related with the radio resources is distinguished from a cell of a geographic area.

The "cell" of the geographic area may be understood as coverage within which a node may provide services using a carrier, and the "cell" of the radio resources is associated with bandwidth (BW), which is a frequency range configured by the carrier. Since DL coverage, which is a range within which the node is capable of transmitting a valid signal, and UL coverage, which is a range within which the node is capable of receiving the valid signal from the UE, depend upon a carrier carrying the signal, coverage of the node may also be associated with coverage of the "cell" of radio resources used by the node. Accordingly, the term "cell" may be used to indicate service coverage by the node sometimes, radio resources at other times, or a range that a signal using the radio resources may reach with valid strength at other times.

In 3GPP communication standards, the concept of the cell is used in order to manage radio resources. The "cell" associated with the radio resources is defined by a combination of DL resources and UL resources, that is, a combination of a DL component carrier (CC) and a UL CC. The cell may be configured by the DL resources only or by the combination of the DL resources and the UL resources. If carrier aggregation is supported, linkage between a carrier frequency of the DL resources (or DL CC) and a carrier frequency of the UL resources (or UL CC) may be indicated by system information. For example, the combination of the DL resources and the UL resources may be indicated by system information block type 2 (SIB2) linkage. In this case, the carrier frequency may be equal to or different from a center frequency of each cell or CC. When carrier aggregation (CA) is configured, the UE has only one radio resource control (RRC) connection with a network. During RRC connection establishment/re-establishment/handover, one serving cell provides non-access stratum (NAS) mobility information. During RRC connection re-establishment/handover, one serving cell provides security input. This cell is referred to as a primary cell (Pcell). The Pcell refers to a cell operating on a primary frequency on which the UE performs an initial connection establishment procedure or initiates a connection re-establishment procedure. According to UE capability, secondary cells (Scells) may be configured to form a set of serving cells together with the Pcell. The Scell may be configured after completion of RRC connection establishment and used to provide additional radio resources in addition to resources of a specific cell (SpCell). A carrier corresponding to the Pcell on DL is referred to as a downlink primary CC (DL PCC), and a carrier corresponding to the Pcell on UL is referred to as an uplink primary CC (UL PCC). A carrier corresponding to the Scell on DL is referred to as a downlink secondary CC (DL SCC), and a carrier corresponding to the Scell on UL is referred to as an uplink secondary CC (UL SCC).

As more and more communication devices have required greater communication capacity, there has been a need for eMBB communication relative to legacy radio access technology (RAT). In addition, massive MTC for providing various services at anytime and anywhere by connecting a plurality of devices and objects to each other is one main issue to be considered in next-generation communication. Further, communication system design considering services/UEs sensitive to reliability and latency is also under discussion. The introduction of next-generation RAT is being discussed in consideration of eMBB communication, massive MTC, ultra-reliable and low-latency communication (URLLC), and the like. Currently, in 3GPP, a study on the next-generation mobile communication systems after EPC is being conducted. In the present disclosure, for convenience, the corresponding technology is referred to as a new RAT (NR) or fifth-generation (5G) RAT, and a system using NR or supporting NR is referred to as an NR system.

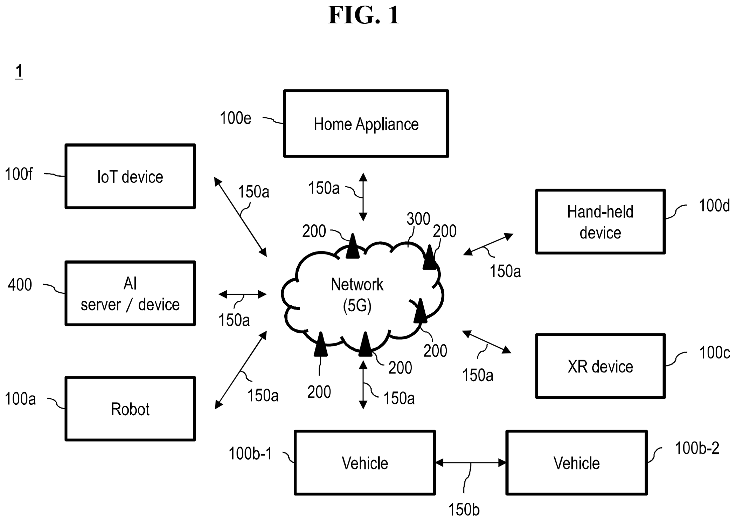

FIG. 1 illustrates an example of a communication system 1 to which implementations of the present disclosure are applied. Referring to FIG. 1, the communication system 1 applied to the present disclosure includes wireless devices, BSs, and a network. Here, the wireless devices represent devices performing communication using RAT (e.g., 5G NR or LTE (e.g., E-UTRA)) and may be referred to as communication/radio/SG devices. The wireless devices may include, without being limited to, a robot 100a, vehicles 100b-1 and 100b-2, an extended reality (XR) device 100c, a hand-held device 100d, a home appliance 100e, an Internet of Things (IoT) device 100f, and an artificial intelligence (AI) device/server 400. For example, the vehicles may include a vehicle having a wireless communication function, an autonomous driving vehicle, and a vehicle capable of performing vehicle-to-vehicle communication. Here, the vehicles may include an unmanned aerial vehicle (UAV) (e.g., a drone). The XR device may include an augmented reality (AR)/virtual reality (VR)/mixed reality (MR) device and may be implemented in the form of a head-mounted device (HMD), a head-up display (HUD) mounted in a vehicle, a television, a smartphone, a computer, a wearable device, a home appliance device, a digital signage, a vehicle, a robot, etc. The hand-held device may include a smartphone, a smartpad, a wearable device (e.g., a smartwatch or smartglasses), and a computer (e.g., a notebook). The home appliance may include a TV, a refrigerator, and a washing machine. The IoT device may include a sensor and a smartmeter. For example, the BSs and the network may also be implemented as wireless devices and a specific wireless device may operate as a BS/network node with respect to another wireless device.

The wireless devices 100a to 100f may be connected to a network 300 via BSs 200. AI technology may be applied to the wireless devices 100a to 100f and the wireless devices 100a to 100f may be connected to the AI server 400 via the network 300. The network 300 may be configured using a 3G network, a 4G (e.g., LTE) network, or a 5G (e.g., NR) network. Although the wireless devices 100a to 100f may communicate with each other through the BSs 200/network 300, the wireless devices 100a to 100f may perform direct communication (e.g., sidelink communication) with each other without passing through the BSs/network. For example, the vehicles 100b-1 and 100b-2 may perform direct communication (e.g., vehicle-to-vehicle (V2V)/Vehicle-to-everything (V2X) communication). The IoT device (e.g., a sensor) may perform direct communication with other IoT devices (e.g., sensors) or other wireless devices 100a to 100f.

Wireless communication/connections 150a and 150b may be established between the wireless devices 100a to 100f and the BSs 200 and between the wireless devices 100a to 100f). Here, the wireless communication/connections such as UL/DL communication 150a and sidelink communication 150b (or, device-to-device (D2D) communication) may be established by various RATs (e.g., 5G NR). The wireless devices and the BSs/wireless devices may transmit/receive radio signals to/from each other through the wireless communication/connections 150a and 150b. To this end, at least a part of various configuration information configuring processes, various signal processing processes (e.g., channel encoding/decoding, modulation/demodulation, and resource mapping/demapping), and resource allocating processes, for transmitting/receiving radio signals, may be performed based on the various proposals of the present disclosure.

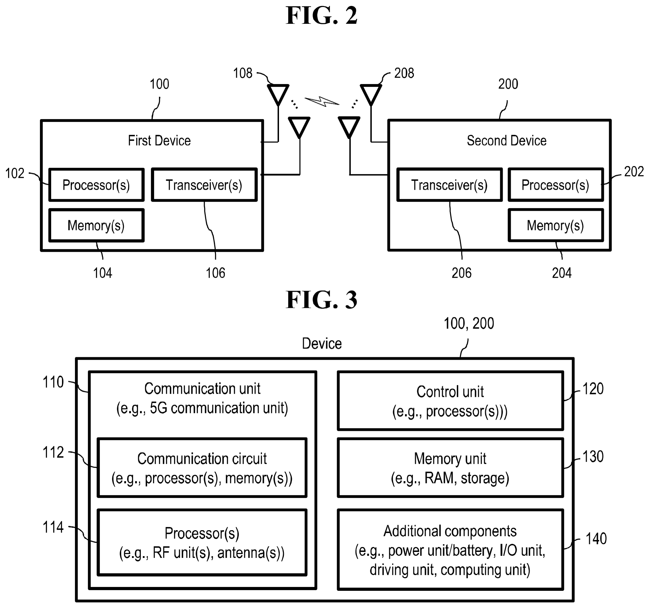

FIG. 2 is a block diagram illustrating examples of communication devices capable of performing a method according to the present disclosure. Referring to FIG. 2, a first wireless device 100 and a second wireless device 200 may transmit and/or receive radio signals through a variety of RATs (e.g., LTE and NR). Here, {the first wireless device 100 and the second wireless device 200} may correspond to {the wireless device 100x and the BS 200} and/or {the wireless device 100x and the wireless device 100x} of FIG. 1.

The first wireless device 100 may include one or more processors 102 and one or more memories 104 and additionally further include one or more transceivers 106 and/or one or more antennas 108. The processor(s) 102 may control the memory(s) 104 and/or the transceiver(s) 106 and may be configured to implement the below-described /proposed functions, procedures, and/or methods. For example, the processor(s) 102 may process information within the memory(s) 104 to generate first information/signals and then transmit radio signals including the first information/signals through the transceiver(s) 106. The processor(s) 102 may receive radio signals including second information/signals through the transceiver(s) 106 and then store information obtained by processing the second information/signals in the memory(s) 104. The memory(s) 104 may be connected to the processor(s) 102 and may store a variety of information related to operations of the processor(s) 102. For example, the memory(s) 104 may perform a part or all of processes controlled by the processor(s) 102 or store software code including instructions for performing the below-described/-proposed procedures and/or methods. Here, the processor(s) 102 and the memory(s) 104 may be a part of a communication modem/circuit/chip designed to implement RAT (e.g., LTE or NR). The transceiver(s) 106 may be connected to the processor(s) 102 and transmit and/or receive radio signals through one or more antennas 108. Each of the transceiver(s) 106 may include a transmitter and/or a receiver. The transceiver(s) 106 is used interchangeably with radio frequency (RF) unit(s). In the present disclosure, the wireless device may represent the communication modem/circuit/chip.

The second wireless device 200 may include one or more processors 202 and one or more memories 204 and additionally further include one or more transceivers 206 and/or one or more antennas 208. The processor(s) 202 may control the memory(s) 204 and/or the transceiver(s) 206 and may be configured to implement the below-described/proposed functions, procedures, and/or methods. For example, the processor(s) 202 may process information within the memory(s) 204 to generate third information/signals and then transmit radio signals including the third information/signals through the transceiver(s) 206. The processor(s) 202 may receive radio signals including fourth information/signals through the transceiver(s) 106 and then store information obtained by processing the fourth information/signals in the memory(s) 204. The memory(s) 204 may be connected to the processor(s) 202 and may store a variety of information related to operations of the processor(s) 202. For example, the memory(s) 204 may perform a part or all of processes controlled by the processor(s) 202 or store software code including instructions for performing the below-described/-proposed procedures and/or methods. Here, the processor(s) 202 and the memory(s) 204 may be a part of a communication modem/circuit/chip designed to implement RAT (e.g., LTE or NR). The transceiver(s) 206 may be connected to the processor(s) 202 and transmit and/or receive radio signals through one or more antennas 208. Each of the transceiver(s) 206 may include a transmitter and/or a receiver. The transceiver(s) 206 is used interchangeably with RF unit(s). In the present disclosure, the wireless device may represent the communication modem/circuit/chip.

The wireless communication technology implemented in the wireless devices 100 and 200 of the present disclosure may include narrowband Internet of things for low-power communication as well as LTE, NR, and 6G. For example, the NB-IoT technology may be an example of low-power wide-area network (LPWAN) technologies and implemented in standards such as LTE Cat NB1 and/or LTE Cat NB2. However, the NB-IoT technology is not limited to the above names. Additionally or alternatively, the wireless communication technology implemented in the wireless devices XXX and YYY of the present disclosure may perform communication based on the LTE-M technology. For example, the LTE-M technology may be an example of LPWAN technologies and called by various names including enhanced machine type communication (eMTC). For example, the LTE-M technology may be implemented in at least one of the following various standards: 1) LTE CAT 0, 2) LTE Cat M1, 3) LTE Cat M2, 4) LTE non-Bandwidth Limited (non-BL), 5) LTE-MTC, 6) LTE Machine Type Communication, and/or 7) LTE M, etc., but the LTE-M technology is not limited to the above names. Additionally or alternatively, the wireless communication technology implemented in the wireless devices XXX and YYY of the present disclosure may include at least one of ZigBee, Bluetooth, and LPWAN in consideration of low-power communication, but the wireless communication technology is not limited to the above names. For example, the ZigBee technology may create a personal area network (PAN) related to small/low-power digital communication based on various standards such as IEEE 802.15.4 and so on, and the ZigBee technology may be called by various names.

Hereinafter, hardware elements of the wireless devices 100 and 200 will be described more specifically. One or more protocol layers may be implemented by, without being limited to, one or more processors 102 and 202. For example, the one or more processors 102 and 202 may implement one or more layers (e.g., functional layers such as a physical (PHY) layer, medium access control (MAC) layer, a radio link control (RLC) layer, a packet data convergence protocol (PDCP) layer, radio resource control (RRC) layer, and a service data adaptation protocol (SDAP) layer). The one or more processors 102 and 202 may generate one or more protocol data units (PDUs) and/or one or more service data units (SDUs) according to the functions, procedures, proposals, and/or methods disclosed in the present disclosure. The one or more processors 102 and 202 may generate messages, control information, data, or information according to the functions, procedures, proposals, and/or methods disclosed in the present disclosure. The one or more processors 102 and 202 may generate signals (e.g., baseband signals) including PDUs, SDUs, messages, control information, data, or information according to the functions, procedures, proposals, and/or methods disclosed in the present disclosure and provide the generated signals to the one or more transceivers 106 and 206. The one or more processors 102 and 202 may receive the signals (e.g., baseband signals) from the one or more transceivers 106 and 206 and acquire the PDUs, SDUs, messages, control information, data, or information according to the functions, procedures, proposals, and/or methods disclosed in the present disclosure.

The one or more processors 102 and 202 may be referred to as controllers, microcontrollers, microprocessors, or microcomputers. The one or more processors 102 and 202 may be implemented by hardware, firmware, software, or a combination thereof. As an example, one or more application specific integrated circuits (ASICs), one or more digital signal processors (DSPs), one or more digital signal processing devices (DSPDs), one or more programmable logic devices (PLDs), or one or more field programmable gate arrays (FPGAs) may be included in the one or more processors 102 and 202. The functions, procedures, proposals, and/or methods disclosed in the present disclosure may be implemented using firmware or software, and the firmware or software may be configured to include the modules, procedures, or functions. Firmware or software configured to perform the functions, procedures, proposals, and/or methods disclosed in the present disclosure may be included in the one or more processors 102 and 202 or stored in the one or more memories 104 and 204 so as to be driven by the one or more processors 102 and 202. The functions, procedures, proposals, and/or methods disclosed in the present disclosure may be implemented using firmware or software in the form of code, commands, and/or a set of commands.

The one or more memories 104 and 204 may be connected to the one or more processors 102 and 202 and store various types of data, signals, messages, information, programs, code, commands, and/or instructions. The one or more memories 104 and 204 may be configured by read-only memories (ROMs), random access memories (RAMs), electrically erasable programmable read-only memories (EPROMs), flash memories, hard drives, registers, cash memories, computer-readable storage media, and/or combinations thereof. The one or more memories 104 and 204 may be located at the interior and/or exterior of the one or more processors 102 and 202. The one or more memories 104 and 204 may be connected to the one or more processors 102 and 202 through various technologies such as wired or wireless connection.

The one or more transceivers 106 and 206 may transmit user data, control information, and/or radio signals/channels, mentioned in the methods and/or operational flowcharts of the present disclosure, to one or more other devices. The one or more transceivers 106 and 206 may receive user data, control information, and/or radio signals/channels, mentioned in the functions, procedures, proposals, methods, and/or operational flowcharts disclosed in the present disclosure, from one or more other devices. For example, the one or more transceivers 106 and 206 may be connected to the one or more processors 102 and 202 and transmit and receive radio signals. For example, the one or more processors 102 and 202 may perform control so that the one or more transceivers 106 and 206 may transmit user data, control information, or radio signals to one or more other devices. The one or more processors 102 and 202 may perform control so that the one or more transceivers 106 and 206 may receive user data, control information, or radio signals from one or more other devices. The one or more transceivers 106 and 206 may be connected to the one or more antennas 108 and 208. The one or more transceivers 106 and 206 may be configured to transmit and receive user data, control information, and/or radio signals/channels, mentioned in the functions, procedures, proposals, methods, and/or operational flowcharts disclosed in the present disclosure, through the one or more antennas 108 and 208. In the present disclosure, the one or more antennas may be a plurality of physical antennas or a plurality of logical antennas (e.g., antenna ports). The one or more transceivers 106 and 206 may convert received radio signals/channels etc. from RF band signals into baseband signals in order to process received user data, control information, radio signals/channels, etc. using the one or more processors 102 and 202. The one or more transceivers 106 and 206 may convert the user data, control information, radio signals/channels, etc. processed using the one or more processors 102 and 202 from the base band signals into the RF band signals. To this end, the one or more transceivers 106 and 206 may include (analog) oscillators and/or filters.

FIG. 3 illustrates another example of a wireless device capable of performing implementation(s) of the present disclosure. Referring to FIG. 3, wireless devices 100 and 200 may correspond to the wireless devices 100 and 200 of FIG. 2 and may be configured by various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the communication circuit 112 may include the one or more processors 102 and 202 and/or the one or more memories 104 and 204 of FIG. 2. For example, the transceiver(s) 114 may include the one or more transceivers 106 and 206 and/or the one or more antennas 108 and 208 of FIG. 2. The control unit 120 is electrically connected to the communication unit 110, the memory 130, and the additional components 140 and controls overall operation of the wireless devices. For example, the control unit 120 may control an electric/mechanical operation of the wireless device based on programs/code/commands/information stored in the memory unit 130. The control unit 120 may transmit the information stored in the memory unit 130 to the exterior (e.g., other communication devices) via the communication unit 110 through a wireless/wired interface or store, in the memory unit 130, information received through the wireless/wired interface from the exterior (e.g., other communication devices) via the communication unit 110.

The additional components 140 may be variously configured according to types of wireless devices. For example, the additional components 140 may include at least one of a power unit/battery, input/output (I/O) unit, a driving unit, and a computing unit. The wireless device may be implemented in the form of, without being limited to, the robot (100a of FIG. 1), the vehicles (100b-1 and 100b-2 of FIG. 1), the XR device (100c of FIG. 1), the hand-held device (100d of FIG. 1), the home appliance (100e of FIG. 1), the IoT device (100f of FIG. 1), a digital broadcast UE, a hologram device, a public safety device, an MTC device, a medicine device, a fintech device (or a finance device), a security device, a climate/environment device, the AI server/device (400 of FIG. 1), the BS (200 of FIG. 1), a network node, etc. The wireless device may be used in a mobile or fixed place according to a use-case/service.

In FIG. 3, the entirety of the various elements, components, units/portions, and/or modules in the wireless devices 100 and 200 may be connected to each other through a wired interface or at least a part thereof may be wirelessly connected through the communication unit 110. For example, in each of the wireless devices 100 and 200, the control unit 120 and the communication unit 110 may be connected by wire and the control unit 120 and first units (e.g., 130 and 140) may be wirelessly connected through the communication unit 110. Each element, component, unit/portion, and/or module within the wireless devices 100 and 200 may further include one or more elements. For example, the control unit 120 may be configured by a set of one or more processors. As an example, the control unit 120 may be configured by a set of a communication control processor, an application processor, an electronic control unit (ECU), a graphical processing unit, and a memory control processor. As another example, the memory 130 may be configured by a random access memory (RAM), a dynamic RAM (DRAM), a read-only memory (ROM)), a flash memory, a volatile memory, a non-volatile memory, and/or a combination thereof.

In the present disclosure, the at least one memory (e.g., 104 or 204) may store instructions or programs, and the instructions or programs may cause, when executed, at least one processor operably connected to the at least one memory to perform operations according to some embodiments or implementations of the present disclosure.

In the present disclosure, a computer readable (non-volatile) storage medium may store at least one instruction or program, and the at least one instruction or program may cause, when executed by at least one processor, the at least one processor to perform operations according to some embodiments or implementations of the present disclosure.

In the present disclosure, a processing device or apparatus may include at least one processor, and at least one computer memory operably connected to the at least one processor. The at least one computer memory may store instructions or programs, and the instructions or programs may cause, when executed, the at least one processor operably connected to the at least one memory to perform operations according to some embodiments or implementations of the present disclosure.

In the present disclosure, a computer program may include program code stored on at least one computer-readable (non-volatile) storage medium and, when executed, configured to perform operations according to some implementations of the present disclosure or cause at least one processor to perform the operations according to some implementations of the present disclosure. The computer program may be provided in the form of a computer program product. The computer program product may include at least one computer-readable (non-volatile) storage medium.

A communication device of the present disclosure includes at least one processor; and at least one computer memory operably connected to the at least one processor and configured to store instructions for causing, when executed, the at least one processor to perform operations according to example(s) of the present disclosure described later.

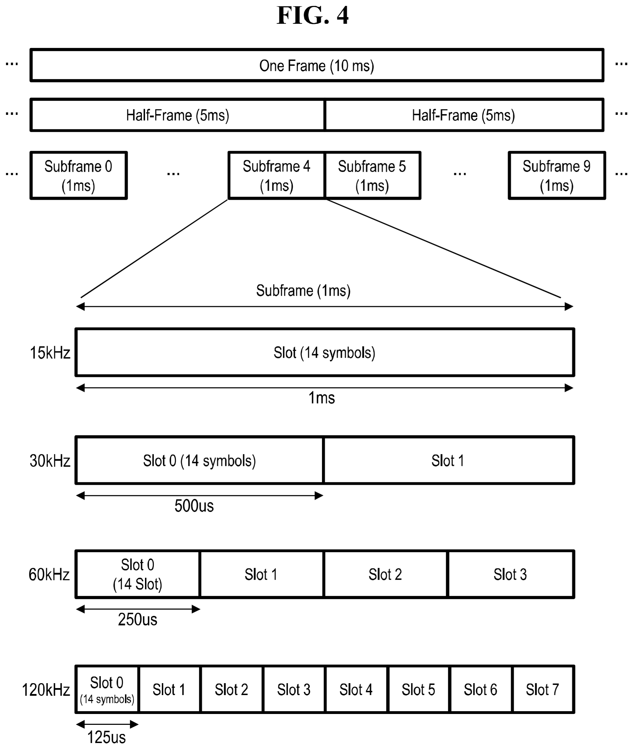

FIG. 4 illustrates an example of a frame structure used in a 3GPP-based wireless communication system.

The frame structure of FIG. 4 is purely exemplary and the number of subframes, the number of slots, and the number of symbols, in a frame, may be variously changed. In an NR system, different OFDM numerologies (e.g., subcarrier spacings (SCSs)) may be configured for multiple cells which are aggregated for one UE. Accordingly, the (absolute time) duration of a time resource including the same number of symbols (e.g., a subframe, a slot, or a transmission time interval (TTI)) may be differently configured for the aggregated cells. Here, the symbol may include an OFDM symbol (or cyclic prefix - OFDM (CP-OFDM) symbol) and an SC-FDMA symbol (or discrete Fourier transform-spread-OFDM (DFT-s-OFDM) symbol). In the present disclosure, the symbol, the OFDM-based symbol, the OFDM symbol, the CP-OFDM symbol, and the DFT-s-OFDM symbol are used interchangeably.

Referring to FIG. 4, in the NR system, UL and DL transmissions are organized into frames. Each frame has a duration of $T_f = (\Delta f_{max} * N_f / 100) * T_c = 10$ ms and is divided into two half-frames of 5 ms each. A basic time unit for NR is $T_c = 1/(\Delta f_{max} * N_f)$ where $\Delta f_{max} = 480 * 10^3$ Hz and $N_f = 4096$. For reference, a basic time unit for LTE is $T_s = 1/(\Delta f_{ref} * N_{f,ref})$ where $\Delta f_{ref} = 15 * 10^3$ Hz and $N_{f,ref} = 2048$. $T_c$ and $T_f$ have the relationship of a constant $\kappa = T_c/T_f = 64$. Each half-frame includes 5 subframes and a duration $T_{sf}$ of a single subframe is 1 ms. Subframes are further divided into slots and the number of slots in a subframe depends on a subcarrier spacing. Each slot includes 14 or 12 OFDM symbols based on a cyclic prefix. In a normal CP, each slot includes 14 OFDM symbols and, in an extended CP, each slot includes 12 OFDM symbols. The numerology depends on an exponentially scalable subcarrier spacing $\Delta f = 2^u * 15$ kHz. The table below shows the number of OFDM symbols ($N^{slot}_{symb}$) per slot, the number of slots ($N^{frame,u}_{slot}$) per frame, and the number of slots ($N^{subframe,u}_{slot}$) per subframe.

Table 1

| $u$ | $N^{slot}_{symb}$ | $N^{frame,u}_{slot}$ | $N^{subframe,u}_{slot}$ |
|---|---|---|---|
| 0 | 14 | 10 | 1 |
| 1 | 14 | 20 | 2 |
| 2 | 14 | 40 | 4 |
| 3 | 14 | 80 | 8 |
| 4 | 14 | 160 | 16 |

The table below shows the number of OFDM symbols per slot, the number of slots per frame, and the number of slots per subframe, according to the subcarrier spacing $\Delta f = 2^u * 15$ kHz.

Table 2

| $u$ | $N^{slot}_{symb}$ | $N^{frame,u}_{slot}$ | $N^{subframe,u}_{slot}$ |
|---|---|---|---|
| 2 | 12 | 40 | 4 |

For a subcarrier spacing configuration u, slots may be indexed within a subframe in ascending order as follows: $n^u_s \in \{0, ..., n^{subframe,u}_{slot} - 1\}$ and indexed within a frame in ascending order as follows: $n^u_{s,f} \in \{0, ..., n^{frame,u}_{slot} - 1\}$.

The slot includes multiple (e.g., 14 or 12) symbols in the time domain. For each numerology (e.g., subcarrier spacing) and carrier, a resource grid of $N^{size,u}_{grid,x} * N^{RB}_{sc}$ subcarriers and $N^{subframe,u}_{symb}$ OFDM symbols is defined, starting at a common resource block (CRB) $N^{start,u}_{grid}$ indicated by higher layer signaling (e.g., RRC signaling), where $N^{size,u}_{grid,x}$ is the number of resource blocks (RBs) in the resource grid and the subscript x is DL for downlink and UL for uplink. $N^{RB}_{sc}$ is the number of subcarriers per RB. In the 3GPP-based wireless communication system, $N^{RB}_{sc}$ is typically 12. There is one resource grid for a given antenna port $p$, a subcarrier spacing configuration $u$, and a transmission link (DL or UL). The carrier bandwidth $N^{size,u}_{grid}$ for the subcarrier spacing configuration u is given to the UE by a higher layer parameter (e.g., RRC parameter). Each element in the resource grid for the antenna port $p$ and the subcarrier spacing configuration $u$ is referred to as a resource element (RE) and one complex symbol may be mapped to each RE. Each RE in the resource grid is uniquely identified by an index $k$ in the frequency domain and an index $l$ representing a symbol location relative to a reference point in the time domain. In the NR system, an RB is defined by 12 consecutive subcarriers in the frequency domain. In the NR system, RBs are classified into CRBs and physical resource blocks (PRBs). The CRBs are numbered from 0 upwards in the frequency domain for the subcarrier spacing configuration $u$. The center of subcarrier 0 of CRB 0 for the subcarrier spacing configuration $u$ is equal to 'Point A' which serves as a common reference point for RB grids. The PRBs for subcarrier spacing configuration $u$ are defined within a bandwidth part (BWP) and numbered from 0 to $N^{size,u}_{BWP,i}$-1, where i is a number of the BWP. The relation between a PRB $n_{PRB}$ in a BWP i and a CRB $n^u_{CRB}$ is given by: $n^u_{PRB} = n^u_{CRB} + N^{size,u}_{BWP,i}$, where $N^{size}_{BWP,i}$ is a CRB in which the BWP starts relative to CRB 0. The BWP includes a plurality of consecutive RBs in the frequency domain. For example, the BWP may be a subset of contiguous CRBs defined for a given numerology $u_i$ in the BWP i on a given carrier. A carrier may include a maximum of N (e.g., 5) BWPs. The UE may be configured to have one or more BWPs on a given component carrier. Data communication is performed through an activated BWP and only a predetermined number of BWPs (e.g., one BWP) among BWPs configured for the UE may be active on the component carrier.

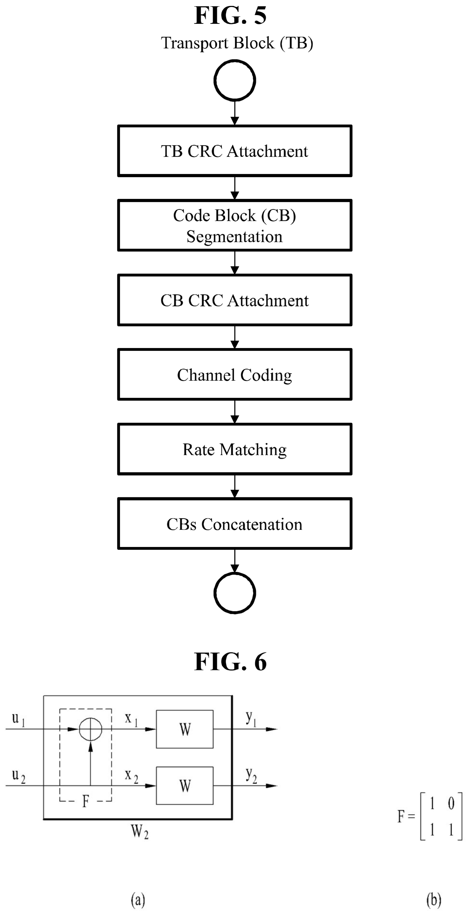

FIG. 5 illustrates a process for processing a transport block (TB) on a transmitting side.

In order for a receiving side to correct errors that radio signals experience in a radio channel, a transmitting side encodes information using a forward error correction code and then transmits the encoded information. The receiving side demodulates a received signal and decodes the error correction code to thereby recover the information transmitted by the transmitting side. In this decoding procedure, errors in the received signal caused by a radio channel are corrected.

Data arrives at a coding block in the form of a maximum of two transport blocks every transmission time interval (TTI) in each DL/UL cell. The following coding steps may be applied to each transport block of the DL/UL cell:

- cyclic redundancy check (CRC) attachment to a transport block;
- code block segmentation and CRC attachment to a code block;
- channel coding;
- rate matching; and
- code block concatenation.

In an actual communication system, a transport block of a predetermined size or larger is divided into a plurality of smaller data blocks and then is encoded, to facilitate actual implementation of coding. The smaller data blocks are called code blocks. While the code blocks are generally of the same size, one of the code blocks may have a different size due to a limited size of an internal interleaver of a channel encoder. Error correction coding is performed on each code block of a predetermined interleaver size and then interleaving is performed to reduce the impact of burst errors that are generated during transmission over a radio channel. The error-corrected and interleaved code block is transmitted by being mapped to an actual radio resource. The amount of radio resources used for actual transmission is designated. Thus, the encoded code blocks are rate-matched to the amount of the radio resources. In general, rate matching is performed through puncturing or repetition. For example, if the amount of radio resources, i.e., the number of transmission bits capable of being transmitted on the radio resources, is M and if a coded bit sequence, i.e., the number of output bits of the encoder, is N, in which M is different from N, then rate matching is performed to match the length of the coded bit sequence to M. If M>N, then all or a part of bits of the coded bit sequence are repeated to match the length of the rate-matched sequence to M. If M<N, then a part of the bits of the coded bit sequence is punctured to match the length of the rate-matched sequence to M and the punctured bits are excluded from transmission.

In wireless communication systems, the transmitting side encodes data to be transmitted based on channel coding with a specific code rate. Then, the transmitting side adjusts the code rate of the data to be transmitted through a rate matching process involving puncturing and repetition.

There are various types of error correction codes, but the size of an information block capable of achieving optimal performance is determined depending on the error correction code. While many coding schemes are available for achieving high-capacity information performance with long information block lengths, the majority of the coding schemes do not consistently show good performance over a wide range of information block lengths and code rates. However, turbo codes, low-density parity check (LPDC) codes, and polar codes show promising BLER performance in a wide range of coding rates and code lengths and hence are considered to be used in the NR system. As demand for various cases such as eMBB, massive IoT, and URLLC has increased, a coding scheme providing greater channel coding efficiency than in turbo codes is needed. In addition, increase in a maximum number of subscribers capable of being accommodated by a channel, i.e., increase in capacity, has been required. Polar codes among various error correction codes are codes providing a new framework capable of solving problems of legacy channel codes and were invented by Arikan at Bilkent University (reference: E. Arikan, "Channel Polarization: A Method for Constructing Capacity-Achieving Codes for Symmetric Binary-Input Memoryless Channels," in IEEE Transactions on Information Theory, vol. 55, no. 7, pp. 3051-3073, July 2009). Polar codes are the first capacity-achieving codes with low encoding and decoding complexities, which were proven mathematically. Polar codes outperform the turbo codes in large information block lengths while no error flow is present. Hereinafter, channel coding using the polar codes is referred to as polar coding.

Polar codes are known as codes capable of achieving the capacity of a given binary discrete memoryless channel. This can be achieved only when a block size is sufficiently large. That is, polar codes are codes capable of achieving the capacity of a channel if the size N of the codes infinitely increases. Polar codes have low encoding and decoding complexity and may be successfully decoded. Polar codes are a sort of linear block error correction codes. Multiple recursive concatenations are basic building blocks for the polar codes and are bases for code construction. Physical conversion of channels in which physical channels are converted into virtual channels occurs and such conversion is based on a plurality of recursive concatenations. If multiple channels are multiplied and accumulated, most of the channels may become better or worse. The idea underlying polar codes is to use good channels. For example, data is sent through good channels at rate 1 and data is sent through bad channels at rate 0. That is, through channel polarization, channels enter a polarized state from a normal state.

FIG. 6 is an example of a block diagram for a polar encoder.

FIG. 6(a) illustrates a base module of a polar code, particularly, first level channel combining for polar coding. In

FIG. 6(a), $W_2$ denotes an entire equivalent channel obtained by combining two binary-input discrete memory less channels (B-DMCs), Ws. Herein, $u_1$ and $u_2$ are binary-input source bits and $y_1$ and $y_2$ are output coded bits. Channel combining is a procedure of concatenating the B-DMCs in parallel.

FIG. 6(b) illustrates a base matrix F for the base module. The binary-input source bits $u_1$ and $u_2$ input to the base matrix F and the output coded bits $x_1$ and $x_2$ of the base matrix F have the following relationship.

$$\text{Equation 1}$$

$$[\, u_1 \ \ u_2 \,]\begin{bmatrix} 1 & 0 \\ 1 & 1 \end{bmatrix} = [\, x_1 \ \ x_2 \,]$$

The channel $W_2$ may achieve symmetric capacity I(W) which is a highest rate. In the B-DMC W, symmetric capacity is an important parameter which is used to measure a rate and is a highest rate at which reliable communication can occur over the channel W. The B-DMC may be defined as follows.

$$\text{Equation 2}$$

$$I(W) = \sum_{y \in Y} \sum_{x \in X} \tfrac{1}{2} W(y|x) \log \frac{w(y|x)}{\tfrac{1}{2} w(y|0) + \tfrac{1}{2} w(y|1)}$$

It is possible to synthesize or create a second set of N binary input channels out of N independent copies of a given B-DMC W and the channels have the properties $\{W_N^{(i)}: 1 <= i <= N\}$. If N increases, there is a tendency for a part of the channels to have capacity approximating to 1 and for the remaining channels to have capacity approximating to 0. This is called channel polarization. In other words, channel polarization is a process of creating a second set of N channels $\{W_N^{(i)}: 1 <= i <= N\}$ using N independent copies of a given B-DMC W. The effect of channel polarization means that, when N increases, all symmetric capacity terms $\{I(W_N^{(i)})\}$ tend towards 0 or 1 for all except a vanishing fraction of indexes i. In other words, the concept behind channel polarization in the polar codes is transforming N copies (i.e., N transmissions) of a channel having a symmetric capacity of I(W) (e.g., additive white Gaussian noise channel) into extreme channels of capacity close to 1 or 0. Among the N channels, an I(W) fraction will be perfect channels and an 1-I(W) fraction will be completely noise channels. Then, information bits are transmitted only through good channels and bits input to the other channels are frozen to 1 or 0. The amount of channel polarization increases along with a block length. Channel polarization consists of two phases: channel combining phase and channel splitting phase.

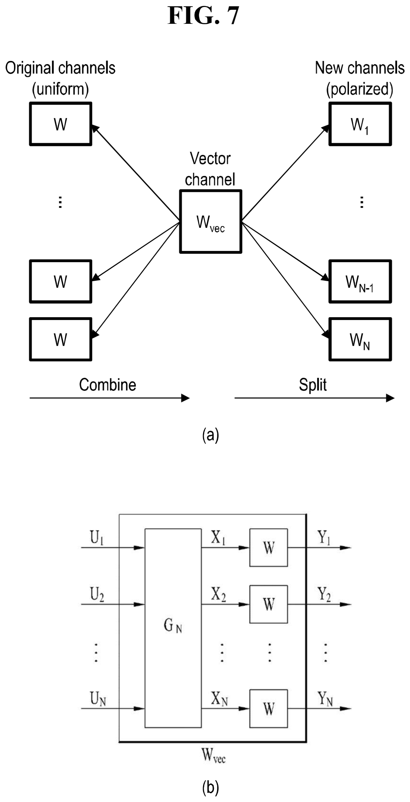

FIG. 7 illustrates the concept of channel combining and channel splitting for channel polarization. As illustrated in FIG. 7, when N copies of an original channel W are properly combined to create a vector channel $W_{vec}$ and then are split into new polarized channels, the new polarized channels are categorized into channels having capacity C(W)=1 and channels having capacity C(W)=0 if N is sufficiently large. In this case, since bits passing through the channels having the channel capacity C(W))=1 are transmitted without error, it is better to transmit information bits therethrough and, since bits passing through the channels having capacity C(W)=0 cannot transport information, it is better to transport frozen bits, which are meaningless bits, therethrough.

Referring to FIG. 7(a), copies of a given B-DMC W are combined in a recursive manner to output a vector channel $W_{vec}$ given by $X_N \rightarrow Y_N$, where $N=2^n$ and n is an integer equal to or greater than 0. Recursion always begins at the 0th level and $W_1 = W$. If n is 1 (n=1), this means the first level of recursion in which two independent copies of $W_1$ are combined. If the above two copies are combined, a channel $W_2: X_2 \rightarrow Y_2$ is obtained. A transitional probability of this new channel $W_2$ may be represented by the following equation.

Equation 3

$$W_2\left(y_1, y_2 \middle| u_1, u_2\right) = W\left(y_1 \middle| u_1 \oplus u_2\right) W\left(y_1 \middle| u_2\right)$$

If the channel $W_2$ is obtained, two copies of the channel $W_2$ are combined to obtain a single copy of a channel $W_4$. Such recursion may be represented by $W_4: X_4 \rightarrow Y_4$ having the following transitional probability.

Equation 4

$$W_4\left(y_1^4 \middle| u_1^4\right) = W_2\left(y_1^2 \middle| u_1 \oplus u_2, u_3 \oplus u_4\right) W_2\left(y_3^4 \middle| u_2, u_4\right)$$

In FIG. 7(b), $G_N$ is a size-N generator matrix. The relationship between input $u_1^N$ to $G_N$ and output $x_1^N$ of $G_N$ of FIG. 7(b) may be represented as $x_1^N = u_1^N G_N$, where $x_1^N = \{x_1, ..., x_N\}$, $u_1^N = \{u_1, ..., u_N\}$. When N B-DMCs are combined, each B-DMC may be expressed in a recursive manner. That is, $G_N$ may be indicated by the following equation.

Equation 5

$$G_N = B_N F^{\mathbf{W}n}$$

Herein, $\otimes$ denotes the Kronecker product, $N=2^n$, n>=1, $F^{\otimes n} = F \otimes F^{\otimes(n-1)}$, and $F^{\otimes 0} = 1$. $B_N$ is a permutation matrix known as a bit-reversal operation and $B_N = R_N(I_2 \otimes B_{N/2})$ and may be recursively computed. $I_2$ is a 2-dimensional identity matrix and this recursion is initialized to $B_2 = I_2$. $R_N$ is a bit-reversal interleaver and is used to map an input $s_1^N = \{s_1, ..., s_N\}$ to an output $x_1^N = \{s_1, s_3, ..., s_{N-1}, s_2, ..., s_N\}$. For example, $G_2$ corresponds to a base matrix F shown in FIG. 6(b). $G_4$ may be expressed as the following matrix.

Equation 6

$$G_4 = \begin{bmatrix} 1 & 0 & 0 & 0 \\ 0 & 0 & 1 & 0 \\ 0 & 1 & 0 & 0 \\ 0 & 0 & 0 & 1 \end{bmatrix} \begin{bmatrix} 1 & 0 \\ 1 & 1 \end{bmatrix}^{\otimes 2} = \begin{bmatrix} 1 & 0 & 0 & 0 \\ 1 & 0 & 1 & 0 \\ 1 & 1 & 0 & 0 \\ 1 & 1 & 1 & 1 \end{bmatrix}$$

A bit-reversal interleaver may not be included on the transmitting side. Without considering the bit-reversal

interleaver, $\mathbf{G}_N$ may be expressed as $\mathbf{G}_N = (\mathbf{G}_2)^{\otimes n}$ (where $N=2^n$). $(\mathbf{G}_2)^{\otimes n}$ denotes the n-th Kronecker power of the matrix $\mathbf{G}_2$, where $\mathbf{G}_2$ is the same as the basic matrix F shown in FIG. 6(b).

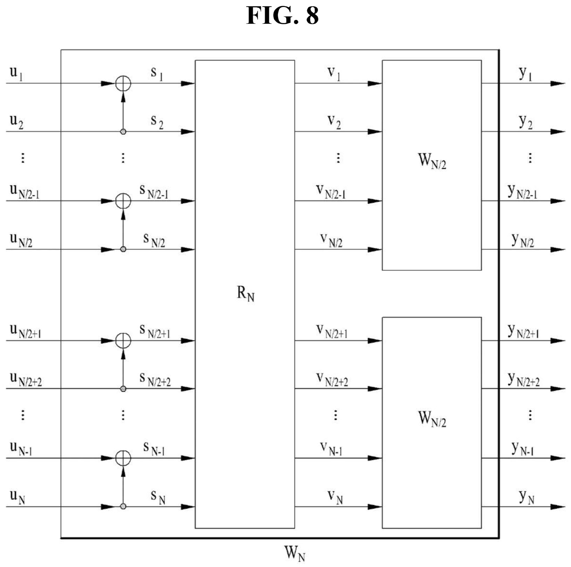

The relationship of Equation 5 is illustrated in FIG. 8.

FIG. 8 illustrates N-th level channel combining for a polar code.

A process of defining an equivalent channel for specific input after combining N B-DMCs Ws is called channel splitting. Channel splitting may be represented as a channel transition probability indicated by the following equation.

Equation 7

$$W_N^i\left(y_1^N, u_1^{i-1} \middle| u_i\right) = \sum_{u_{i+1}^N} \frac{1}{2^{N-1}} W_N\left(y_1^N \middle| u_1^N\right)$$

Channel polarization has the following characteristics:

> Conservation: $C(W^-) + C(W^+) = 2C(W)$,
> Extremization: $C(W^-) <= C(W) <= C(W^+)$.

When channel combining and channel splitting are performed, the following theorem may be obtained.

* Theorem: For any B-DMC W, channels $\{W_N^{(i)}\}$ are polarized in the following sense. For any fixed $\delta \in \{0,1\}$, as N goes to infinity through powers of 2, the fraction of indexes $i \in \{1,...,N\}$ for channel capacity $I(W_N^{(i)}) \in (1-\delta,1]$ goes to $I(W)$ and the faction of i for channel capacity $I(W_N^{(i)}) \in [0,\delta)$ goes to $1-I(W)$. Hence, if $N \to \infty$, then channels are perfectly noisy or are polarized free of noise. These channels can be accurately recognized by the transmitting side. Therefore, bad channels are fixed and non-fixed bits may be transmitted on good channels.

That is, if the size N of polar codes is infinite, a channel has much noise or is free of noise, with respect to a specific input bit. This has the same meaning that the capacity of an equivalent channel for a specific input bit is divided into 0 or I(W).

Inputs of a polar encoder are divided into bit channels to which information data is mapped and bit channels to which the information data is not mapped. As described earlier, according to the theorem of the polar code, if a codeword of the polar code goes to infinity, the input bit channels may be classified into noiseless channels and noise channels. Therefore, if information is allocated to the noiseless bit channels, channel capacity may be obtained. However, in actuality, a codeword of an infinite length cannot be configured, reliabilities of the input bit channels are calculated and data bits are allocated to the input bit channels in order of reliabilities. In the present disclosure, bit channels to which data bits are allocated are referred to as good bit channels. The good bit channels may be input bit channels to which the data bits are mapped. Bit channels to which data is not mapped are referred to as frozen bit channels. A known value (e.g., 0) is input to the frozen bit channels and then encoding is performed. Any values which are known to the transmitting side and the receiving side may be mapped to the frozen bit channels. When puncturing or repetition is performed, information about the good bit channels may be used. For example, positions of codeword bits (i.e., output bits) corresponding to positions of input bits to which information bits are not allocated may be punctured.

A decoding scheme of the polar codes is a successive cancellation (SC) decoding scheme. The SC decoding scheme obtains a channel transition probability and then calculates a log-likelihood ratio (LLR) of input bits using the channel transition probability. In this case, the channel transition probability may be calculated in a recursive form if channel combining and channel splitting procedures use characteristics of the recursive form. Therefore, a final LLR value may also be calculated in the recursive form. First, a channel transition probability $W_N^{(i)}(y_1^N, u_1^{i-1}|u_1)$ of an input bit $u_i$ may be obtained as follows. $u_1^i$ may be split into odd indexes and even indexes as expressed as $u_{1,o}^i$, $u_{1,e}^i$, respectively. The channel transition probability may be indicated by the following equations.

Equation 8

$$W_{2N}^{(2i-1)}(y_1^{2N}, u_1^{2i-1}|u_{2i-1})$$

$$= \sum_{u_{2i}^{2N}} \frac{1}{2^{2N-1}} W_{2N}(y_1^{2N}|u_1^{2N})$$

$$= \sum_{u_{2i,o}^{2N}, u_{2i,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \sum_{u_{2i}} \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \sum_{u_{2i}} \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

*where* $\quad W_N^{(i)}(y_1^N, u_1^{i-1}|u_i) = \sum_{u_{i+1}^N} \frac{1}{2^{N-1}} W_N(y_1^N|u_1^N)$ .

Equation 9

$$W_{2N}^{(2i)}(y_1^{2N}, u_1^{2i-1}|u_{2i})$$

$$= \sum_{u_{2i+1}^{2N}} \frac{1}{2^{2N-1}} W_{2N}(y_1^{2N}|u_1^{2N})$$

$$= \sum_{u_{2i+1,o}^{2N}, u_{2i+1,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

A polar decoder retrieves information and generates an estimate $u^{\wedge N}_1$ of $u^N_1$ using values (e.g., reception bits, frozen bits, etc.) known for the polar codes. The LLR is defined as follows.

Equation 10

$$L_N^{(i)}(y_1^N, u_1^{i-1}) = \frac{W_N^{(i)}(y_1^N, u_1^{i-1}|u_i = 0)}{W_N^{(i)}(y_1^N, u_1^{i-1}|u_i = 1)}$$

The LLR may be recursively calculated as follows.

Equation 11

$$L_N^{(2i-1)}(y_1^N, \hat{u}_1^{2i-2}) = \frac{L_{N/2}^{(i)}(y_1^{N/2}, \hat{u}_{1,o}^{2i-2} \oplus \hat{u}_{1,e}^{2i-2}) \cdot L_{N/2}^{(i)}(y_{N/2+1}^N, \hat{u}_{1,e}^{2i-2}) + 1}{L_{N/2}^{(i)}(y_1^{N/2}, \hat{u}_{1,o}^{2i-2} \oplus \hat{u}_{1,e}^{2i-2}) + L_{N/2}^{(i)}(y_{N/2+1}^N, \hat{u}_{1,e}^{2i-2})}$$

$$L_N^{(2i)}(y_1^N, \hat{u}_1^{2i-1}) = [L_{N/2}^{(i)}(y_1^{N/2}, \hat{u}_{1,o}^{2i-2} \oplus \hat{u}_{1,e}^{2i-2})]^{1-2\hat{u}_{2i-1}} \cdot L_{N/2}^{(i)}(y_{N/2+1}^N, \hat{u}_{1,e}^{2i-2})$$

Recursive calculation of LLRs is traced back to a code length of 1 with an LLR $L^{(1)}_1(y_i) = W(y_i|0)/W(y_i|1)$. $L^{(1)}_1(y_i)$ is soft information observed from a channel.

The complexity of a polar encoder and an SC decoder varies with the length N of polar codes and is known as having O(MogN). Assuming that K input bits are used for a length-N polar code, a coding rate becomes N/K. If a generator matrix of a polar encoder of a data payload size N is $G_N$, an encoded bit may be represented as $x^N_1 = u^N_1 G_N$. It is assumed that K bits out of $u^N_1$ correspond to payload bits, a row index of $G_N$ corresponding to the payload bits is i, and a row index of $G_N$ corresponding to (N-K) bits is F. A minimum distance of the polar codes may be given as $d_{min}(C) = min_{i \in I} 2^{wt(i)}$, where wt(i) is the number of 1s within binary extension of i and i=0,1,...,N-1.

SC list (SCL) decoding is an extension of a basic SC decoder. In this type of decoder, L decoding paths are simultaneously considered in each decoding stage. Herein, L is an integer. In other words, in the case of the polar codes, a list-L decoding algorithm is an algorithm for simultaneously tracking L paths in a decoding process.

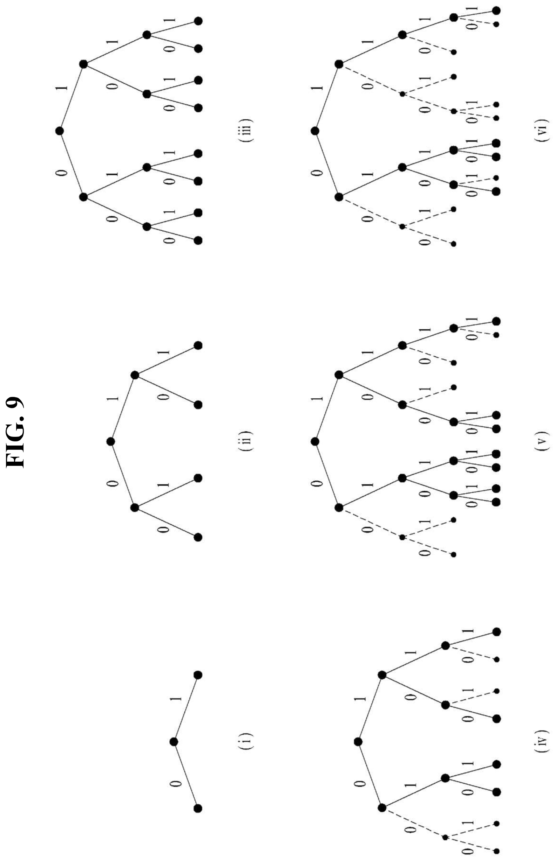

FIG. 9 illustrates an evolution of decoding paths in a list-L decoding process. For convenience of description, it is assumed that the number of bits that should be determined is n and all bits are not frozen. If a list size L is 4, each level includes at most 4 nodes with paths that continue downward. Discontinued paths are expressed by dotted lines in FIG. 9. A process in which decoding paths evolve in list-L decoding will now be described with reference to FIG. 9. i) If list-L decoding is started, the first unfrozen bit may be either 0 or 1. ii) list-L decoding continues. The second unfrozen bits may be either 0 or 1. Since the number of paths is not greater than L=4, pruning is not needed yet. iii) Consideration of all options for the first bit (i.e., a bit of the first level), the second bit (i.e., a bit of the second level), and the third bit (i.e., a bit of the third level) results in 8 decoding paths which are excessive because L=4. iv) the 8 decoding paths are pruned to L (=4) promising paths. v) 4 active paths continue by considering two options of the fourth unfrozen bit. In this case, the number of paths is doubled, i.e., 8 paths which are excessive because L=4. vi) The 8 paths are pruned back to L (=4) best paths. In the example of FIG. 7, 4 candidate codewords 0100, 0110, 0111, and 1111 are obtained and one of the codewords is determined to be a codeword most similar to an original codeword. In a similar manner to a normal decoding process, for example, in a pruning process or a process of determining a final codeword, a path in which the sum of LLR absolute values is largest may be selected as a survival path. If a CRC is present, the survival path may be selected through the CRC.

Meanwhile, CRC-aided SCL decoding is SCL decoding using CRC and improves the performance of polar codes. CRC is the most widely used technique in error detection and error correction in the field of information theory and coding. For example, if an input block of an error correction encoder has K bits and the length of information bits is k, and the length of CRC sequences is m bits, then K = k + m. CRC bits are a part of source bits for an error correction code. If the size of channel codes used for encoding is N, a code rate R is defined as R=K/N. CRC aided SCL decoding serves to detect an errorless path while a receiving device confirms a CRC code with respect to each path. An SCL decoder outputs candidate sequences to a CRC detector. The CRC detector feeds back a check result in order to aid in determining a codeword.

Although complicated as compared with an SC algorithm, SCL decoding or CRC aided SCL decoding has an advantage of excellent decoding performance. For more details of a list-L decoding algorithm of the polar codes, refer to 'I. Tal and A. Vardy, "List decoding of polar codes," in Proc. IEEE Int. Symp. Inf. Theory, pp. 1-5, Jul. 2011'.

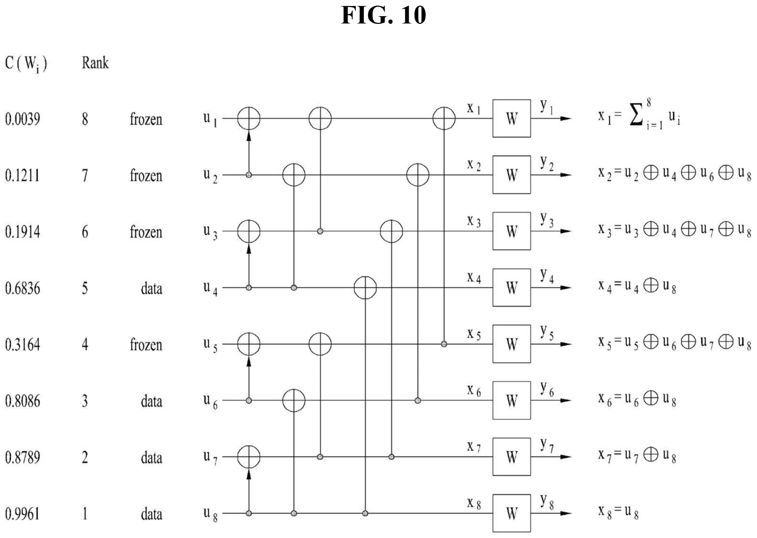

FIG. 10 illustrates the concept of selecting position(s) to which information bit(s) are to be allocated in polar codes.

In the example of FIG. 10, it is assumed that the size N of mother codes is 8, i.e., the size N of polar codes is 8, and a code rate is 1/2.

In FIG. 10, $C(W_i)$ denotes the capacity of a channel $W_i$ and corresponds to the reliability of channels that input bits of a polar code experience. When channel capacities corresponding to input bit positions of the polar code are as illustrated in FIG. 10, reliabilities of the input bit positions are ranked as illustrated in FIG. 10. To transmit data at a code rate of 1/2, a transmitting device allocates 4 bits constituting the data to 4 input bit positions having high channel capacities among 8 input bit positions (i.e., input bit positions denoted as $u_4$, $u_6$, $u_7$, and $u_8$ among input bit positions $u_1$ to $u_8$ of FIG. 10) and freezes the other input bit positions. A generator matrix $G_8$ corresponding to the polar code of FIG. 10 is as follows. The generator matrix $G_8$ may be acquired based on $(G_2)^{\otimes n}$.

$$\text{Equation 12}$$

$$G_8 = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

The input bit positions denoted as $u_1$ to $u_8$ of FIG. 10 correspond one by one to rows from the highest row to the lowest row of $G_8$. Referring to FIG. 10, it may be appreciated that the input bit corresponding to $u_8$ affects all output coded bits. On the other hand, it may be appreciated that the input bit corresponding to $u_1$ affects only $y_1$ among the output coded bits. Referring to Equation 12, when binary-input source bits $u_1$ to $u_8$ are multiplied by $G_8$ a row in which the input bits appear at all output bits is the lowest row [1, 1, 1, 1, 1, 1, 1, 1] in which all elements are 1, among rows of $G_8$. Meanwhile, a row in which the binary-input source bits appears at only one output bit is a row in which one element is 1 among the rows of $G_8$, i.e., a row [1, 0, 0, 0, 0, 0, 0, 0] in which a row weight is 1. Similarly, it may be appreciated that a row in which a row weight is 2 reflects input bits corresponding to the row in two output bits. Referring to FIG. 10 and Equation 12, $u_1$ to $u_8$ correspond one by one to the rows of $G_8$ and bit indexes for distinguishing between input positions of $u_1$ to $u_8$, i.e., bit indexes for distinguishing between the input positions, may be assigned to the rows of $G_8$.

Hereinafter, for Polar codes, it may be assumed that bit indexes from 0 to N-1 are sequentially allocated to rows of $G_N$ starting from the highest row having the smallest row weight with respect to N input bits. For example, referring to FIG. 10, a bit index 0 is allocated to the input position of $u_1$, i.e., the first row of $G_8$ and a bit index 7 is allocated to the input position of $u_8$, i.e., the last row of $G_8$. However, since the bit indexes are used to indicate input positions of the polar code, a scheme different from the above allocation scheme may be used. For example, bit indexes from 0 to N-1 may be allocated staring from the lowest row having the largest row weight.

In the case of output bit indexes, as illustrated in FIG. 10 and Equation 12, it may be assumed that bit indexes from 0 to N-1 or bit indexes from 1 to N are assigned to columns from the first column having the largest column weight to the last column having the smallest column weight among columns of $G_N$.

In Polar codes, setting of information bits and frozen bits is one of the most important elements in the configuration and performance of the polar code. That is, determination of ranks of input bit positions may be an important element in the performance and configuration of the polar code. For Polar codes, bit indexes may distinguish input or output positions of the polar code. In the present disclosure, a sequence obtained by enumerating reliabilities of bit positions in ascending or descending order are referred to as a bit index sequence or polar sequence. That is, the bit index sequence represents reliabilities of input or output bit positions of the polar code in ascending or descending order. A transmitting device inputs information bits to input bits having high reliabilities based on the input bit index sequence and performs encoding using the polar code. A receiving device may discern input positions to which information bits are allocated or input positions to which frozen bits are allocated, using the same or corresponding input bit index sequence. That is, the receiving device may perform polar decoding using an input bit index sequence which is identical to or corresponds to an input bit index sequence used by the transmitting device and using a corresponding polar code. In the following description, it may be assumed that an input bit index sequence is predetermined so that information bit(s) may be allocated to input bit position(s) having high reliabilities. In the present disclosure, the input bit index sequence is also called a Polar sequence.

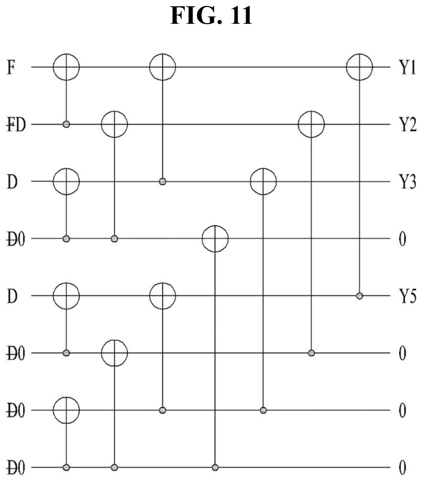

FIG. 11 illustrates puncturing and information bit allocation for polar codes. In FIG. 11, F denotes a frozen bit, D denotes an information bit, and 0 denotes a skipping bit.

Among coded bits, the case in which an information bit is changed to a frozen bit may occur according to an index or position of a punctured bit. For example, if output coded bits for a mother code of N=8 should be punctured in order of Y8, Y7, Y6, Y4, Y5, Y3, Y2, and Y1 and a target code rate is 1/2, then Y8, Y7, Y6, and Y4 are punctured, U8, U7, U6, and U4 connected only to Y8, Y7, Y6, and Y4 are frozen to 0, and these input bits are not transmitted, as illustrated in FIG. 9. An input bit changed to a frozen bit by puncturing of a coded bit is referred to as a skipping bit or a shortening bit and a corresponding input position is referred to as a skipping position or a shortening position. Shortening is a rate matching method of inserting a known bit into an input bit position connected to a position of an output bit desired to be transmitted while maintaining the size of input information (i.e., the size of information blocks). Shortening is possible starting from input corresponding to a column in which a column weight is 1 in a generator matrix $G_N$ and next shortening may be performed with respect to input corresponding to a column in which a column weight is 1 in a remaining matrix from which a column and row in which a column weight is 1 are removed. To prevent all information bits from being punctured, an information bit that should have been allocated to an information bit position may be reallocated in order of a high reliability within a set of frozen bit positions.

In the case of the polar code, decoding may be generally performed in the following order.

> 1. Bit(s) having low reliabilities are recovered first. Although reliability differs according to the structure of a decoder, since an input index in an encoder (hereinafter, an encoder input bit index or bit index) having a low value usually has a low reliability, decoding is generally performed staring from a low encoder input bit index.
> 2. When there is a known bit for a recovered bit, the known bit is used together with the recovered bit or the process of 1 is omitted and a known bit for a specific input bit position is immediately used, thereby recovering an information bit, which is an unknown bit. The information bit may be a source information bit (e.g., a bit of a transport block) or a CRC bit.

As described above, since a polar encoder has different reliability depending on input positions, the transmitting side may allocate a data block (i.e., an information block before encoding) to bit channel(s) in order of reliability according to the size of the corresponding data block and perform encoding by setting all others to be frozen (e.g., with a value of '0'). For example, if the mother code size of the polar encoder (i.e., the maximum size of a code block that the polar encoder is capable of encoding) is N, and if the size of a data block input to the polar encoder is K, polar encoding is performed by arranging the bits of the data block in order of reliability in K bit channels and setting 0 to N-K bit channel(s).

The following shows the polar sequence used in NR (5G) systems (see the polar sequence defined in 3GPP TS 38.212 Rel-15).

< Polar sequence>

| W | I | W | I | W | I | W | I | W | I | W | I | W | I | W | I |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |

(continued)

| W | I | W | I | W | I | W | I | W | I | W | I | W | I | W | I |
|---|---|---|---|---|---|---|---|---|---|---|---|---|---|---|---|
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |

(continued)

| W | I | W | I | W | I | W | I | W | I | W | I | W | I | W | I |
|---|---|---|---|---|---|---|---|---|---|---|---|---|---|---|---|
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |

(continued)

| W | I | W | I | W | I | W | I | W | I | W | I | W | I | W | I |
|---|---|---|---|---|---|---|---|---|---|---|---|---|---|---|---|
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

The above table shows a Polar sequence $\mathbf{Q}_0^{Nmax-1}$ and a reliability $W(Q_i^{Nmax})$ of the Polar sequence. In the above table, $W$ denotes $W(Q_i^{Nmax})$ and $I$ denotes $Q_i^{Nmax}$. Namely, the Polar sequence $\mathbf{Q}_0^{Nmax-1} = \{Q_0^{Nmax}, Q_1^{Nmax},..., Q_{Nmax-1}^{Nmax}\}$ is given by the above table, where $0<=Q_i^{Nmax}<=Nmax-1$ denotes a bit index (i.e., bit channel index) before Polar encoding for i=0,1,...,Nmax-1. For 3GPP TS 38.212 Rel-15, Nmax = 1024. The Polar sequence $\mathbf{Q}_0^{Nmax-1}$ is ascending order of reliability $W(Q_0^{Nmax})<W(Q_1^{Nmax})<...<W(Q_{Nmax-1}^{Nmax})$, where $W(Q_i^{Nmax})$ denotes the reliability of bit index $Q_i^{Nmax}$. For example, referring to the above table, a reliability $W(Q_i^{Nmax})=3$ of a bit index $Q_i^{Nmax}=4$ is lower than a reliability $W(Q_i^{Nmax})=7$ of bit index $Q_i^{Nmax}=3$. That is, the above table lists, in ascending order of reliability, bit indexes 0 to 1023 which respectively indicate 1024 input positions of a Polar code of Nmax=1024.

For any information block encoded to N bits, a same Polar sequence $\mathbf{Q}_0^{N-1} = \{Q_0^N, Q_1^N, Q_2^N,..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$. For example, when N=8, a Polar sequence $\mathbf{Q}_0^7$ includes elements of $Q_i^{Nmax}<8$ among elements of the Polar sequence $\mathbf{Q}_0^{Nmax-1}$ and the elements of $Q_i^{Nmax}<8$ are ordered in ascending order of reliability $W(0)<W(1)<W(2)<W(4)<W(3)<W(5)<W(6)$.

For example, Table 3 lists input bit positions for an information block of size K (=10) input to a Polar code in a Polar sequence of N=512.

Table 3

|  | Polar sequence |
|---|---|
| 1 | 505 |
| 2 | 506 |
| 3 | 479 |
| 4 | 508 |
| 5 | 495 |
| 6 | 503 |

(continued)

| | Polar sequence |
|---|---|
| 7 | 507 |
| 8 | 509 |
| 9 | 510 |
| 10 | 511 |

Table 3 shows 10 elements for K=10 among elements of the Polar sequence of N=512 in ascending order of reliability. Referring to the above-described table of <Polar sequence>, values of I having 10 reliabilities $W(Q_i^{Nmax})$ among values of I ($=Q_i^{Nmax}$) less than N=512 are {479, 495, 503, 505, 506, 507, 508, 509, 510, 511}. If {479, 495, 503, 505, 506, 507, 508, 509, 510, 511} are arranged in ascending order of reliability $W$, {505, 506, 479, 508, 495, 503, 507, 509, 510, 511}, which is a set of bit indexes for K=10 in the Polar sequence of N=512 shown in Table 3, may be obtained.

If the bit sequence input to channel coding is denoted by $c_0, c_1, c_2, c_3, ..., c_{K-1}$, the bits after encoding are denoted by $d_0, d_1, d_2, d_3, ..., d_{N-1}$, where K is the number of bits to encode, where $N=2^n$.

For any information block encoded to N bits, a same Polar sequence $\mathbf{Q}_0^{N-1} = \{Q_0^N, Q_1^N, Q_2^N, ..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N) < W(Q_1^N) < W(Q_2^N) < ... < W(Q_{N-1}^N)$.

In some implementations, if the input is $\mathbf{u} = [u_0\ u_1\ u_2\ ...\ u_{N-1}]$ in polar encoding, the output after encoding, $\mathbf{d}=[d_0\ d_1\ d_2\ d_3\ ...\ d_{N-1}]$, is obtained by $\mathbf{d}=\mathbf{u}\mathbf{G}_N$, and the encoding may be performed in GF(2).

A list successive cancellation decoder used in a conventional polar code decoding has a disadvantage of high implementation complexity and latency because the list successive cancellation decoder performs sorting operations at each bit. To address this issue, a permutation decoding method has been proposed, which performs decoding by shuffling the order of received signals.

If a vector $\pi(c)$, formed by rearranging the codeword c of a code C using a permutation $\pi$, belongs to the original code C, then the permutation $\pi$ is called an automorphism. A permutation decoder generates candidate vectors by permuting received signals based on several automorphisms and decodes the vectors in parallel. Unlike a successive cancellation list (SCL) decoder, the permutation decoder allows for complete parallelization and does not require a sorter, thereby dramatically improving implementation complexity and latency.

To apply permutation decoding, it is important to find an automorphism (permutation) that makes a codeword valid even after the order of codes is shuffled. Algebraic codes such as Bose-Chaudhuri-Hocquenghem (BCH) codes may be easily shuffled using cyclic shifts. That is, when cyclic shifts are used, simple permutations that satisfy the automorphism conditions may be found. For example, in the case of BCH codes, different permutations may be generated by changing a shift parameter s based on a cyclic shift defined as follows: $\sigma^s([c_1, c_2, c_3, ..., c_N])= [c_{N-s+1}, c_{N-s+2}, ..., c_N, c_1, c_2, ..., c_{N-s}]$.

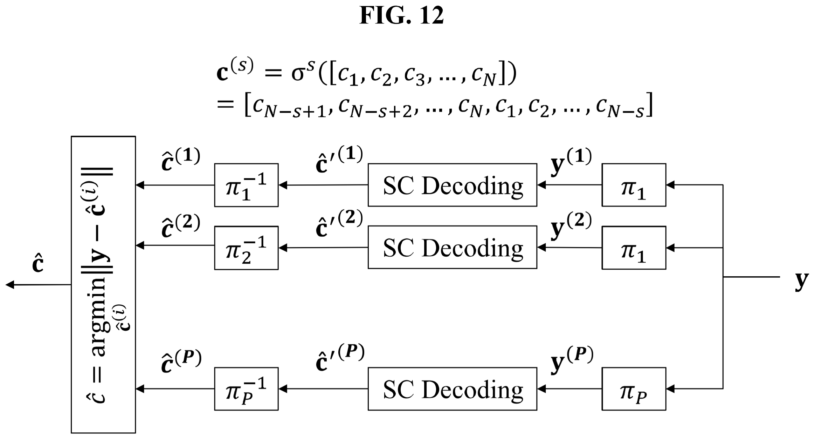

FIG. 12 illustrates an example of a permutation decoder. Referring to FIG. 12, in some implementations, the permutation decoder generates P decoding paths, perform decoding by applying different permutations to the P paths, and performs permutation decoding by selecting a codeword closest to a received signal. However, for permutation decoding, the decoding performance may vary depending on the value of s, and the optimal value of s needs to be determined based on the received signal.

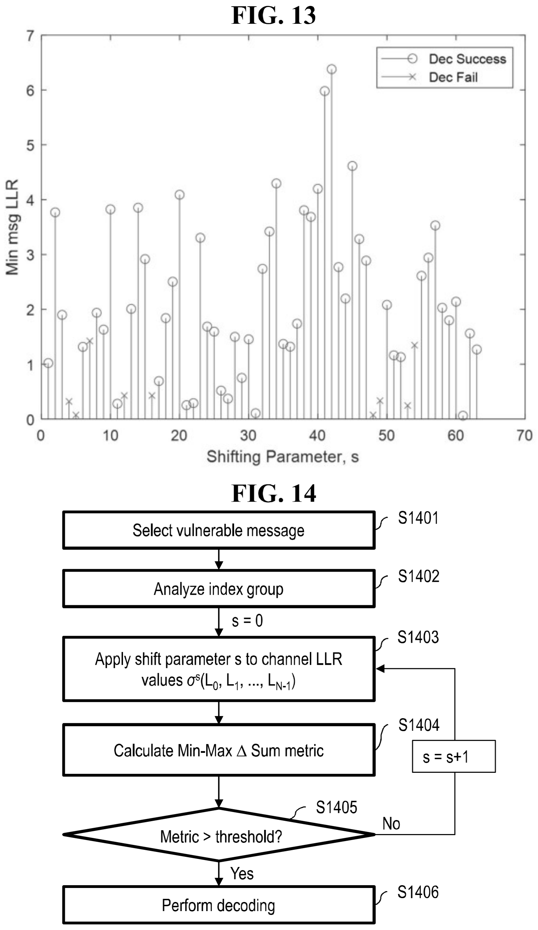

FIG. 13 illustrates that decoding performance may vary depending on a permutation (shift) parameter. In particular, FIG. 13 illustrates the simulation results of permutation decoding for code size N = 64, information size of K = 32, and SNR = 3 dB. In FIG. 13, "Dec Success" indicates decoding success, and "Dec Fail" indicates decoding failure. The success or failure of decoding is related to the minimum value of the log-likelihood ratios (LLRs) of a message. Referring to FIG. 13, it is observed that as the LLR of the message decreases, the probability of decoding failure increases. If a shift parameter that increases the message LLR is capable of being identified, the decoding success rate may be improved.

Therefore, an appropriate permutation is necessary to improve the performance of permutation decoding. If applying different permutations to a received vector results in the same decoding results as SC decoding with no permutation, the performance gain relative to the complexity may be reduced. Thus, it is important to find a permutation that guarantees different decoding results. In other words, the decoding performance of a permutation decoder depends on the shift parameter s, and it is crucial to select the shift parameter s based on the received vector. Hereinafter, some implementations of the present disclosure for determining the optimal shift parameter by analyzing the signal strength distribution from the received signal will be described.

FIG. 14 illustrates a decoding process according to some implementations of the present disclosure.

A successive cancellation (SC) or list successive cancellation (list-SC) decoder for polar codes sequentially calculates the LLRs of a message: $L^{(0)}$, $L^{(1)}$, ..., $L^{(N-1)}$ from the LLRs of a channel: $L_0$, $L_1$, ..., $L_{N-1}$. During this process, a polarization phenomenon occurs in the distribution of the message LLRs. As a code length N increases, some message LLRs approach a confidence level close to 0, while others LLRs approach a confidence level close to $\infty$. In this case, messages with a confidence level of 0 are set to values shared between the receiver and transmitter, while communication may be performed by embedding actual messages in messages with an infinite confidence level. In finite-length codes, since there are messages that experience partial polarization, there are messages that do not have an infinite confidence level. Such vulnerable messages with partial polarization are the cause of degraded decoding performance.

Some implementations of the present disclosure relate to method(s) for improving the performance of a permutation decoder in polar code decoders in order to reduce computational complexity. According to some implementations of the present disclosure, when the LLR values of a received vector are given, the effect of a received LLR on a vulnerable message is analyzed, and the LLR values of the vulnerable message are guided to increase based on a shift permutation. Some implementations of the present disclosure may include shifting a received signal such that the highest LLR is transferred to the most vulnerable message (e.g., the most vulnerable bit) among information messages (e.g., the bits of the received signal).

To this end, a decoder according to some implementations of the present disclosure selects a vulnerable message (i.e., a vulnerable bit) from received information messages (i.e., received bits) (S1401). For example, the decoder according to some implementations of the present disclosure may select a vulnerable bit i based on SC error analysis, which analyzes the relationship between bits with errors and LLR values. The value of a vulnerable message LLR $L_N^{(i)}$ among received signals of length N may be expressed as a function of channel LLRs, $L_0$, $L_1$, ..., $L_{N-1}$ as follows: $L_N^{(i)} = f(L_0, L_1, ..., L_{N-1})$.

The indices of the bit channels of the polar code may be partitioned (or grouped) based on the index i of the vulnerable message (S1402). The index of the vulnerable message (hereafter referred to as a vulnerable index) is predefined. The index of the vulnerable message changes only depending on the channel and does not change according to the shift parameter.

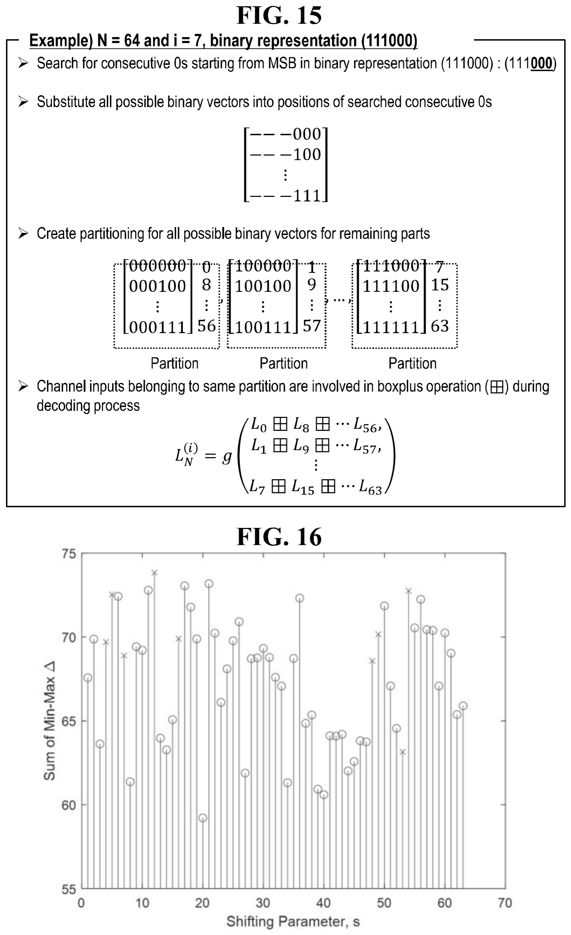

FIG. 15 is a diagram for explaining a process of partitioning channels according to some implementations of the present disclosure.

In some implementations of the present disclosure, an index [0 : N-1] may be partitioned through the following process. For example, when N = 64 and message 7 among N messages (messages 0 to N-1) is a vulnerable message, the index of the vulnerable message is i = 7. According to a binary representation where the most significant bit (MSB) is placed at the rightmost position (i.e., the binary representation for the index i is defined as $(b_1, b_2, ..., b_n)$), i = 7 may be represented by a 6-bit binary representation (111000) because N = 64. If consecutive 0s are searched from the MSB in the binary representation (111000), (111<u>000</u>) is obtained. If all possible binary vectors are substituted into the positions of the consecutive 0s, binary vectors capable of being substituted into the positions of the three consecutive 0s range from (---000) to (---111), resulting in 8 possible vectors. When (000) is substituted into the first three positions, a partition is created/determined with elements $L_0$, $L_8$, ..., L56. By converting the binary representation within the partition to a decimal form, channel indices may be obtained. Thus, each element of the partition may be matched with a channel index. Channel inputs belonging to the same partition participate a boxplus operation in the decoding process.

In summary, message LLRs are generated by applying the following boxplus operation or summation operation to channel LLRs:

$$> \text{Boxplus operation: } x \boxplus y = 2 \operatorname{atanh}(\tanh(x)\tanh(y))$$

$$> \text{Summation operation: } x + y$$

When the binary representation for the index i of the vulnerable message is $(b_1, b_2, ..., b_n)$, if $b_j$ is 0, the boxplus operation is applied. If $b_j$ is 1, the summation operation is applied. Based on the binary vector $(b_n, b_{n-1}, ..., b_1)$ of the vulnerable message, the channel LLR indices obtained by the boxplus operation may be identified. For example, if the index of the vulnerable message is i = 1 = (100), the LLR of the message, $L^{(1)}$ may be calculated according to the following equation.

Equation 13

$$L^{(1)} = L_0 \boxplus L_2 \boxplus L_4 \boxplus L_6 + L_1 \boxplus L_3 \boxplus L_5 \boxplus L_7$$

When i = 1 = (100) is partitioned according to the process described above, for (-00), (-01), (-10), (-11), if 0 is substituted into the "-" positions, the following groups are obtained: one group of (000) = 0, (001) = 4, (010) = 2, (011) = 6; and another group of (100) = 1, (101) = 5, (110) = 3, (111) = 7. Since the elements of the indices within each group are grouped using the boxplus operation, Equation 13 may be derived.

In Equation 13, it is assumed that channel inputs ($L_0$, $L_2$, $L_4$, $L_6$) that are grouped together by the boxplus operation are Group 1 (i.e., Partition 1), and other channel inputs ($L_1$, $L_3$, $L_5$, $L_7$) that are grouped together by the boxplus operation is Group 2 (i.e., Partition 2). The value of the boxplus operation for each group is determined by the smallest LLR value within the group. That is, the LLR of the message $L^{(7)}$ may be approximated as follows.

Equation 14

$$L^{(1)} = \min(|L_0|, |L_2|, |L_4|, |L_6|) + \min(|L_1|, |L_3|, |L_5|, |L_7|)$$

If there is even one low LLR value within a group, the overall operation result may decrease. Therefore, by applying a shift such that low received LLRs are not spread across multiple groups but are concentrated within a specific group, the decrease in the message LLR value may be prevented. Considering this, in some implementations of the present disclosure, the difference between the largest LLR and the smallest LLR in each group is calculated, and the sum of these difference values across all groups, min-max $\Delta$ sum, is defined as a metric for the distribution state of LLRs.

When the decoder according to some implementations of the present disclosure performs a shift on a received signal (S 1403), the decoder proceeds with decoding (S 1406) only if the min-max $\Delta$ sum value exceeds a specific threshold (Yes in S1405). Each time the metric exceeds the threshold, the decoding may be attempted. The decoding may be attempted up to a maximum of P times, where P is the number of permutations. If the min-max $\Delta$ sum value for a certain shift parameter s is smaller than the specified threshold (No in S1405), the min-max $\Delta$ sum value for another shift parameter may be calculated to determine whether to apply the other shift parameter to the permutation. The specified threshold may be determined through iterative experiments.

Referring again to FIG. 14, for example, assuming that Group (0, 3) and Group (1, 2) are generated by grouping, if a received signal L0, L1, L2, L3 is not shifted, (L0, L3) are grouped together as one group, and (L1, L2) are grouped together as another group. Assuming that a signal obtained by shifting the received signal once is L3, L0, L1, L2, (L3, L2) are grouped together as one group, and (L0, L1) are grouped together as another group. The decoding result depends on how the groups are formed. The probability of success increases as the min-max $\Delta$ sum increases with the shift. Thus, decoding is attempted when the value exceeds the threshold.

FIG. 16 illustrates a comparison of the sum of the minimum-maximum differences of LLR groups based on permutation (shift) parameters. In particular, FIG. 16 shows the simulation results of permutation decoding by assuming that mother code size N = 64, information size K = 32, and noise strength (SNR) in additive white Gaussian noise (AWGN) channel = 3 dB. FIG. 16 demonstrates that the min-max $\Delta$ sum is capable of being used as a metric for implementations of the present disclosure. This data may also be used to determine the specific threshold described above.

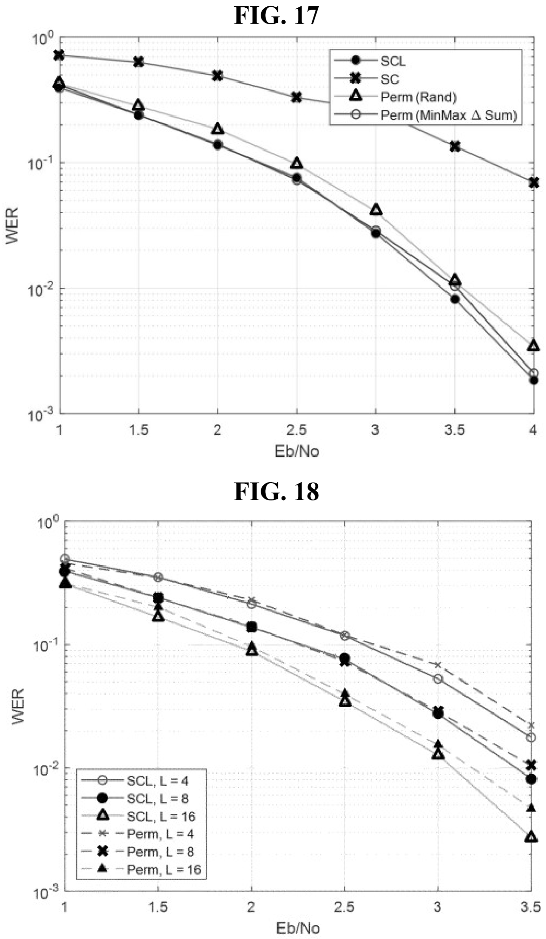

FIG. 17 illustrates a comparison of the performance of a decoding method that selects a shift parameter according to some implementations of the present disclosure with other decoding methods. In particular, FIG. 17 shows a comparison of word error rate (WER) performance between SCL decoding, SC decoding, permutation decoding where a shift parameter is randomly selected and applied, and permutation decoding where a shift parameter is selected and applied according to some implementations of the present disclosure when the number of paths is set to 8 (i.e., list size L = 8) for an extended BCH code with a code length of 64 and a message length of 36 (i.e., mother code size N = 64 and information size K = 36 for the encoder). Referring to FIG. 17, the permutation decoding where the shift parameter is applied according to some implementations of the present disclosure shows similar WER performance to that of SCL decoding, and the permutation decoding shows better WER performance than that of existing permutation decoding where a random shift parameter is applied.

FIG. 18 illustrates a comparison of the performance between a decoding method that selects a shift parameter according to some implementations of the present disclosure and an SCL decoding method. In particular, FIG. 18 shows a comparison of WER performance between SCL decoding with a list size L and decoding according to some implementations of the present disclosure, for an extended BCH code with mother code size N = 64 and information size K = 32. Referring to FIG. 18, for different list sizes, the decoding according to some implementations of the present disclosure shows WER performance similar to that of SCL decoding. The decoder according to some implementations of the present disclosure allows for complete parallelization, unlike the SCL decoder and does not require a sorter, thereby dramatically improving implementation complexity and latency while still achieving WER performance similar to that of the SCL decoder.

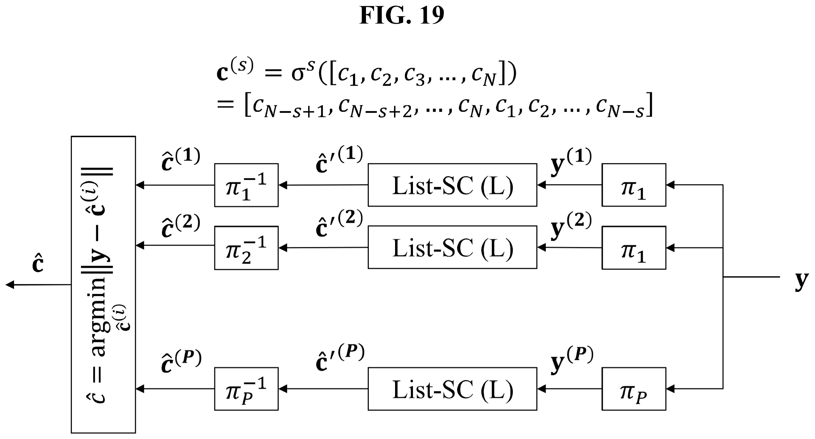

FIG. 19 illustrates another example of a permutation decoder. Referring to FIG. 19, SCL decoding with a list size L is applied to each permutation path.

In some implementations of the present disclosure, the decoding process proceeds by permuting a received signal with different shift parameters to generate P received signals and then decoding each of the P received signals with a list-SC decoder (i.e., SCL decoder) with a list size L.

In this case, even if a total parallelism of L*P, is the same, the total complexity and performance may vary depending on how each value is configured. For example, for a code with mother code size N = 64 and total parallelism L*P = 32, if L = 32 and P = 1, it is equivalent to performing single list-SC decoding, which provides excellent performance. However, since the list-SC decoder requires additional sorting operations, the decoding complexity increases. On the other hand, for total parallelism L*P = 32, if L = 1 and P = 32, each decoder may operate in parallel without the need for sorting operations, thereby reducing the complexity. However, the same results may be obtained from parallel paths. For example, when decoding fails for the topmost path in FIG. 19, it is expected that decoding for a path below where the shift is applied will succeed. However, there may be cases where the decoding similarly fails. Therefore, for total parallelism L*P = 32, when L = 1 and P = 32, the decoding performance may degrade. By combining the number of parallel paths related to permutations (i.e., the number of permutation paths) P and the list size L, it is possible to find the optimal balance between performance and complexity.

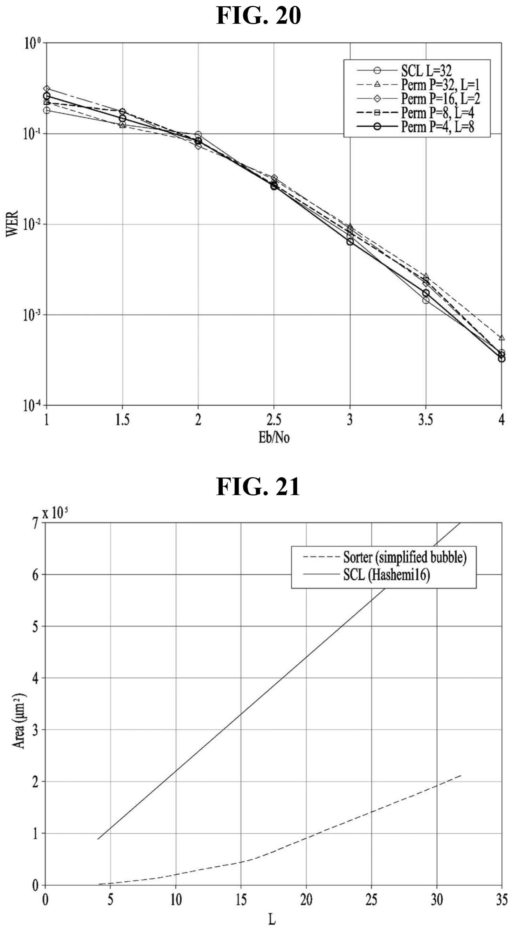

FIG. 20 illustrates the performance of permutation-based SCL decoding depending on the number of permutation paths and list sizes. In particular, FIG. 20 shows a comparison of WER performance depending on P and L without normalization, for an extended BCH code with a code length of N = 64 and a message length of 36. Here, P represents the number of parallel permutation paths, and L represents the list size of SCL decoding. Referring to FIG. 20, it is observed that, for the same total parallelism, the performance is best when L = 32 and P = 1. However, if L and P are properly combined, similar performance may be achieved when L = 8 and P = 4.

The following table shows a required sorter area based on the list size L (reference: Balatsoukas-Stimming, M. Bastani Parizi, and A. Burg, "On metric sorting for successive cancellation list decoding of polar codes," 2015 IEEE International Symposium on Circuits and Systems (ISCAS), 2015, pp. 1993-1996).

Table 4

|  | Pruned Radix ($\mu m^2$) | Pruned Bitonic ($\mu m^2$) | Simplified Bubble ($\mu m^2$) |
|---|---|---|---|
| L=4 | 3703 | 3965 | 2756 |
| L=8 | 18770 | 20748 | 11726 |
| L = 16 | 70746 | 69769 | 51159 |
| L = 32 | 376945 | 205478 | 212477 |

Meanwhile, each time the list size increases by 1, an SCL decoder requires an additional area of approximately 226,000 $\mu m^2$ (reference: S. A. Hashemi, A. Balatsoukas-Stimming, P. Giard, C. Thibeault, and W. J. Gross, "Partitioned successive-cancellation list decoding of polar codes," 2016 IEEE International Conference on Acoustics, Speech and Signal Processing (ICASSP), 2016, pp. 957-960).

FIG. 21 illustrates required areas for a sorter and SCL decoder depending on list sizes. Referring to FIG. 21, the area of the sorter increases exponentially with the list size, while the area of the SCL decoder increases linearly with the list size.

The following table shows latency (the number of cycles) required according to the list size L, where a mother code size of N = 512 and a code rate of R = 0.5 are used (reference: K. Lee and I. Park, "Large-Small Sorting for Successive Cancellation List Decoding of Polar Codes," in IEEE Access, vol. 8, pp. 96955-96962, 2020).

Table 5

|  | L = 4 | L = 8 | L = 16 |
|---|---|---|---|
| Sort Latency | 1584 | 3168 | 5280 |
| SCL Latency | 5697 | 7281 | 9391 |

Referring to Table 5, as the list size L increases, the overhead of a sorter also increases.

The complexity of an SCL decoder and sorter may be compared by the total computational load obtained by summing the operations of an adder and comparator. The following table shows a comparison of the total computational load of the sorter and SCL decoder depending on the list size L for an extended BCH code with mother code size N = 64 and information size K = 36.

Table 6

| L | 8 | 16 | 32 | 64 | 128 |
|---|---|---|---|---|---|
| Sorter | 864 | 2304 | 5760 | 13824 | 32256 |

(continued)

| L | 8 | 16 | 32 | 64 | 128 |
|---|---|----|----|----|-----|
| SCL | 3072 | 6144 | 12288 | 24576 | 49152 |

The following table shows the complexity of SCL decoding and permutation decoding for an extended BCH code with mother code size N = 64 and information size K = 36. Here, P represents the number of parallel permutation paths, and L represents the list size.

Table 7

|  | SCL (L=32) | Perm (P=32, L=1) | Perm (P=16, L=2) | Perm (P=8, L=4) | Perm (P=4, L=8) |
|---|---|---|---|---|---|
| Total operations | 18048 | 12288 | 13440 | 14592 | 15744 |

When normalization is performed by assuming that permutation decoding has the same operations as SCL decoding, parameters normalized with respect to P and L may be obtained as follows:

Table 8

|  | SCL (L=32) | Perm (P=32, L=1) | Perm (P=16, L=2) | Perm (P=8, L=4) | Perm (P=4, L=8) |
|---|---|---|---|---|---|
| Normalized parameter | L=32 | P=47, L=1 | P=21, L=2 | P=10, L=4 | P=5, L=8 |

In this case, when the complexity of each combination is converted into the total number of operations for comparison, it may be expressed as follows:

Table 9

|  | P=1, L=32 | P=32, L=1 | P=16, L=2 | P=8, L=4 | P=4, L--8 |
|---|---|---|---|---|---|
| Total complexity of operations | 18,048 | 12,288 | 13,440 | 14,592 | 15,744 |

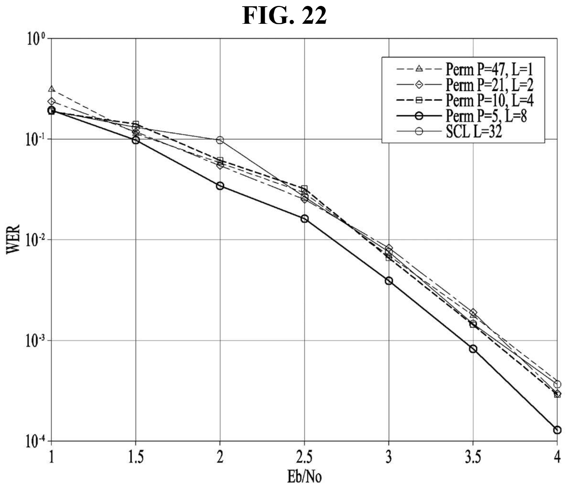

Accordingly, when the number of parallel paths P for permutation decoding is adjusted by assuming a fixed computational complexity (e.g., the same computational complexity as when P = 1 and L = 32, which is 18048), the WER performance normalized to the complexity may be obtained as shown in FIG. 22. FIG. 22 illustrates a comparison of normalized WER performance based on computational complexity when P = 32 and L = 1 for an extended BCH code with mother code size of N = 64 and information size K = 36. Referring to FIG. 22, if the complexity is the same, it is observed that permutation decoding with P = 5 and L = 8 has the best performance and the permutation decoding has better performance than that when SCL = 32. In some implementations of the present disclosure, when the WER performance is compared for normalized combinations of P and L based on a fixed complexity, combinations of (P, L) with lower WER performance may be determined.

In summary, in some implementations of the present disclosure, normalized combinations of P and L may be obtained for a mother code size of N based on a fixed computational complexity. By comparing the performance of permutation decoding for each combination of P and L, the combination of P and L with the best performance, for example, the lowest WER may be selected as the number of parallel paths P and the list size L for permutation decoding.

A communication device or decoder may perform operations related to channel decoding according to some implementations of the present disclosure. The communication device or the decoder may include: at least one transceiver; at least one processor; and at least one computer memory operably connected to the at least one processor and storing instructions that, when executed, cause the at least one processor to perform operations according to some implementations of the present disclosure. A processing device for the communication device or decoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure. For the communication device, decoder, computer-readable (non-volatile) storage medium, and/or computer program product, the operations may include: receiving a signal related to a first bit sequence with a length of N from another communication device, where N is an integer greater than 1; determining P different shift parameters for the first bit sequence, where P is an integer greater than 1; generating P second bit sequences by cyclically shifting the first bit sequence based on the P different shift parameters; and determining a codeword by performing successive cancellation decoding with a list size of L on each of the P second bit sequences, where L is an integer greater than 0. Determining the P different shift parameters for the first bit sequence includes determining a shift parameter s satisfying the following: an index i of a vulnerable bit among N bits of the first bit sequence is determined; operation values (e.g., channel LLR values) for the first bit sequence are grouped into a plurality of groups based on the index i of the vulnerable bit; and a predefined metric (e.g., the sum of the differences between the minimum and maximum values) for the plurality of groups exceeds a predetermined threshold, wherein the predefined metric is obtained by summing differences between largest and smallest operation values for each of the plurality of groups. In some implementations, grouping the operation values into the plurality of groups based on the index i of the vulnerable bit may include: based on a binary representation of the index i of the vulnerable bit, $(b\_1, b\_2, ..., b\_(n-1))$, determining to apply a boxplus operation for $b\_j = 0$ and to apply a summation operation for $b\_j = 1$; and determining indices of operation values combined by the boxplus operation among the operation values as one group.

In some implementations, the first bit sequence may include bits obtained by the other communication device by encoding information bits with a length of K with an error correction code with a size of N.

In some implementations, the operations may include: determining combinations of candidates for a number of permutation paths and candidate list sizes based on a fixed complexity for a parallelism of N/2; and determining a combination with optimal performance based on decoding performance of each of the combinations. A candidate for the number of permutation paths and a candidate list size of the combination with the optimal performance may be used as P and L, respectively.

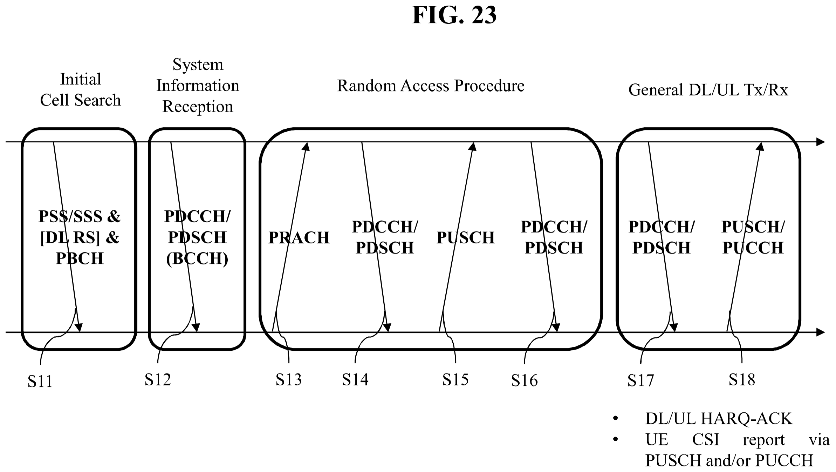

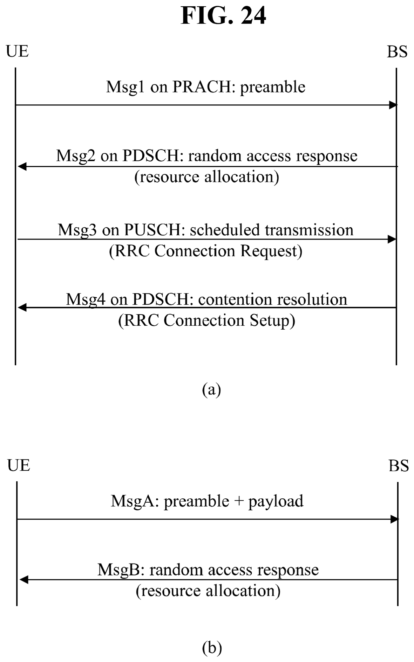

In some implementations of the present disclosure, the communication device or decoder may establish a radio resource control (RRC) connection for communication with another communication device (e.g., UE or BS) and receive the signal related to the first bit sequence of length N from the other communication device. For example, based on the signal transmission/reception processes described in FIGS. 23 and 24, the communication device may receive a signal including part or all of the first bit sequence over a physical channel (e.g., physical uplink control channel (PUCCH), physical uplink shared channel (PUSCH), physical downlink control channel (PDCCH), physical downlink shared channel (PDSCH), physical broadcast channel (PBCH), physical sidelink control channel (PSCCH), physical sidelink shared channel (PSSCH), or physical sidelink broadcast channel (PSBCH)) from the other communication device. The physical channel may carry a rate-matched codeword obtained by perform rate matching for a codeword (e.g., codeword of length N) of uplink control information (UCI), uplink shared channel (UL-SCH) data, a master information block (MIB) that is part of minimum system information, downlink control information (DCI), downlink shared channel (DL-SCH) data, or sidelink shared channel (SL-SCH) data. The communication device or encoder transmitting the rate-matched codeword may perform rate matching for the codeword based on radio resources allocated for the transmission of the codeword and the target code rate for the corresponding physical channel. The communication device or encoder may transmit the rate-matched codeword as a transmission sequence to the other communication device. The communication device or decoder that receives the rate-matched codeword may obtain the first bit sequence of length N from the received signal.

FIG. 23 illustrates physical channels used in a 3GPP-based communication system, which is an example of a wireless communication system, and a signal transmission/reception process using the channels.

When the UE is powered on or when the UE has been disconnected from the wireless communication system, the UE searches for a cell to camp on and performs initial cell search involving synchronization with a BS in the cell (S11). For the initial cell search, the UE receives a synchronization signal block (SSB) (also referred to as a SSB/PBCH block) from the BS. The SSB includes a primary synchronization signal (PSS), a secondary synchronization signal (SSS), and a physical broadcast channel (PBCH). The UE establishes synchronization with the BS based on the PSS/SSS and acquires information such as a cell identity (ID). The UE may acquire broadcast information in a cell based on the PBCH. The UE may receive a DL reference signal (RS) in an initial cell search procedure to monitor a DL channel status.

After initial cell search, the UE may camp on the cell. Subsequently, the UE may monitor a PDCCH in the cell and acquire more specific system information by receiving a PDSCH based on DCI carried on the PDCCH (S12).

Subsequently, to complete connection to the BS, the UE may perform a random access procedure (S13 to S16). In the random access procedure, for example, the UE may transmit a preamble on a PRACH (S13) and receive a PDCCH and a random access response (RAR) for the preamble on a PDSCH corresponding to the PDCCH (S14). When the UE fails in receiving the RAR directed to the UE, the UE may attempt to retransmit the preamble. In the case of contention-based random access, the UE may transmit a PUSCH based on a UL resource assignment included in the RAR (S15), and perform a contention resolution procedure including reception of a PDCCH and a PDSCH corresponding to the PDCCH (S16).

After the above procedure, the UE may receive a PDCCH/PDSCH from the BS (S17) and transmit a PUSCH/-

PUCCH to the BS (S19) in a general UL/DL signal transmission procedure. Control information that the UE transmits to the BS is generically called uplink control information (UCI). The UCI includes a hybrid automatic repeat and request acknowledgement/negative acknowledgement (HARQ ACK/NACK), a scheduling request (SR), and channel state information (CSI). The CSI includes a channel quality indicator (CQI), a precoding matrix indicator (PMI), and/or a rank indication (RI). In general, UCI is transmitted on the PUCCH. However, when control information and data should be transmitted simultaneously, the control information may be transmitted on the PUSCH. In addition, the UE may transmit the UCI aperiodically on the PUSCH, upon receipt of a request/command from a network.

FIG. 24 illustrates random access procedures applicable to implementation(s) of the present disclosure. Particularly, FIG. 24(a) illustrates a 4-step random access procedure, and FIG. 24(b) illustrates a 2-step random access procedure.

A random access procedure may be used for various purposes including initial access, UL synchronization adjustment, resource allocation, handover, radio link reconfiguration after radio link failure, and positioning. Random access procedures are classified into a contention-based procedure and a dedicated (i.e., non-contention-based) procedure. The contention-based random access procedure generally involves initial access, whereas the dedicated random access procedure is used for UL synchronization reconfiguration in the event of handover, DL data arrival at a network, and positioning.

A PRACH preamble configuration to be used may be provided to the UE. Multiple RACH preamble formats (i.e., PRACH preamble formats) are defined by one or more RACH OFDM symbols and different cyclic prefixes (CPs) (and/or guard periods). The PRACH preamble configuration for a cell provides available PRACH preamble formats and RACH occasion(s) on the cell to the UE. The RACH occasion refers to time-frequency resources available for transmission/reception of RA preamble(s). In some scenarios, a single RACH occasion (RO) for all available RA preambles capable of being transmitted on the cell is configured by an RRC message (e.g., SIB2 of the cell). In other scenarios, SSBs may be selected in association with different beams, and the association between SSBs and RACH occasions may be provided by the BS to the UE. SSBs associated with different DL beams of the cell may be identified by different SSB indices, where each SSB index may represent a different DL beam. The BS provides a set of available RACH occasions for transmission of RA preambles through a PRACH configuration, which includes a PRACH preamble configuration, and also provides RACH occasion(s) associated with SSBs. For example, the number of SSBs associated with a single RACH occasion may be provided to the UE by a higher layer (e.g., RRC) parameter SSB-perRACH-Occasion. Based on the PRACH configuration for the cell, each SSB transmitted on the cell is associated with one or more RACH occasions. The BS may provide the number of preambles per SSB to the UE through the PRACH configuration. For example, the number of preambles per SSB may be provided based on the value of a higher layer parameter cb-preamblePerSSB. Based on the values of SSB-perRACH-Occasion and cb-preamblePerSSB, the total number of preambles per SSB for each RACH occasion may be determined. SSB indices may be mapped to RACH occasions in the following order:

- First, in the order of increasing preamble indices within a single RACH occasion;
- Second, in the order of increasing frequency resource indices for frequency-multiplexed RACH occasions;
- Third, in the order of increasing time resource indices for time-multiplexed RACH occasions within a RACH slot; or
- Fourth, in the order of increasing RACH slots.

In some scenarios where SSBs are associated with different DL beams, the UE may detect one or more SSBs on a cell. The UE may select an SSB from the detected SSBs (either randomly or based on reference signal received power (RSRP)). The UE may then determine a RACH occasion associated with the selected SSB based on a PRACH configuration. The UE may transmit an RA preamble on the determined RACH occasion. The BS may monitor available RACH occasions on the cell. Based on the RACH occasion where the RA preamble is received, the BS may determine which SSB the UE selects from the SSBs with different SSB indices transmitted on the cell when transmitting the RA preamble. Based on the SSB selected by the UE, the BS may determine an appropriate DL beam for the UE.

In the contention-based random access procedure, the UE selects a random access (RA) preamble. In the contention-based random access procedure, it is possible for a plurality of UEs to simultaneously transmit the same RA preamble, and thus a subsequent contention resolution process is required. In the dedicated random access procedure, the UE uses an RA preamble uniquely allocated to the UE by the BS. Therefore, the UE may perform the random access procedure without collision with other UEs.

Referring to FIG. 24(a), the contention-based random access procedure includes the following four steps. The messages transmitted in steps 1 to 4 may be referred to as message 1 (Msg1) to message 4 (Msg4), respectively.

- Step 1: The UE transmits an RA preamble on a PRACH.
- Step 2: The UE receives an RAR on a PDSCH from the BS.
- Step 3: The UE transmits UL data on a PUSCH to the BS. The UL data includes a Layer 2 (L2)/Layer 3 (L3) message.
- Step 4: The UE receives a contention resolution message on the PDSCH from the BS.

The UE may receive random access information in system information from the BS. When the UE needs random access, the UE transmits Msg1 (e.g., a preamble) on a PRACH to the BS. The BS may identify each RA preamble by a time/frequency resource (hereinafter, RA occasion (RO)) carrying the RA preamble, and a random access preamble index (PI). Upon receipt of the RA preamble from the UE, the BS transmits a random access response (RAR) message to the UE on a PDSCH. To receive the RAR message, the UE monitors an L1/L2 control channel (e.g., PDCCH) with a cyclic redundancy check (CRC) masked with a random access-RNTI (RA-RNTI), including scheduling information for the RAR message, within a preconfigured time window (e.g., ra-ResponseWindow). When receiving scheduling information on the PDCCH masked with the RA-RNTI, the UE may receive an RAR message on a PDSCH indicated by the scheduling information. The UE then checks whether there is an RAR directed to the UE in the RAR message. The presence or absence of the RAR directed to the UE may be determined by checking whether there is a random access preamble ID (RAPID) for the preamble transmitted by the UE. The index of the preamble transmitted by the UE may be identical to the RAPID. The RAR includes the index of the corresponding RA preamble, timing offset information (e.g., timing advance command (TAC)) for UL synchronization, UL scheduling information (e.g., UL grant) for Msg3 transmission, and UE temporary identification information (e.g., temporary-C-RNTI (TC-RNTI)). Upon receipt of the RAR, the UE transmits Msg3 on a PUSCH according to the UL scheduling information and the timing offset value in the RAR. Msg3 may include the ID (or global ID) of the UE. Further, Msg3 may include RRC connection request-related information (e.g., RRCSetupRequest message) for initial access to the network. After receiving Msg3, the BS transmits a contention resolution message, that is, Msg4 to the UE. When the UE receives the contention resolution message and succeeds in contention resolution, the TC-RNTI is changed to a C-RNTI. Msg4 may include the ID of the UE/RRC connection-related information (e.g., an RRCSetup message). When information transmitted in Msg3 does not match information received in Msg4 or when the UE has not received Msg4 for a predetermined time, the UE may determine that the contention resolution has failed and retransmit Msg3. Upon successfully resolving the contention, the UE may transition to the RRC_CONNECTED state. When the UE is in the RRC_CONNECTED state, RRC messages may be exchanged between the RRC layer of the UE and the RRC layer of the BS. In other words, the UE in the RRC_CONNECTED state refers to the UE that establishes an RRC connection with the BS

The dedicated random access procedure includes the following three steps. Messages transmitted in step 0 to step 2 may be referred to as Msg0 to Msg2, respectively. The BS may trigger the dedicated random access procedure by a PDCCH serving the purpose of commanding RA preamble transmission (hereinafter, referred to as a PDCCH order).

- Step 0: The BS allocates an RA preamble to the UE by dedicated signaling.
- Step 1: The UE transmits the RA preamble on a PRACH.
- Step 2: The UE receives an RAR on a PDSCH from the BS.

Step 1 and step 2 of the dedicated random access procedure may be the same as step 1 and step 2 of the contention-based random access procedure.

The wireless communication system to be introduced may require lower latency than the legacy system. Particularly for a latency-sensitive service such as URLLC, the 4-step random access procedure may not be preferable. A low-latency random access procedure may be needed for various scenarios in the wireless communication system. When implementation(s) of the present disclosure are realized along with a random access procedure, the implementation(s) of the present disclosure may be carried out together with the following 2-step random access procedure to reduce latency involved in the random access procedure.

Referring to FIG. 24(b), the 2-step random access procedure may be performed in two steps: transmission of MsgA from the UE to the BS and transmission of MsgB from the BS to the UE. The MsgA transmission may include transmission of an RA preamble on a PRACH and transmission of UL payload on a PUSCH. In the MsgA transmission, the PRACH and the PUSCH may be transmitted in time division multiplexing (TDM). Alternatively, the PRACH and the PUSCH may be transmitted in frequency division multiplexing (FDM) in the MsgA transmission.

Upon receipt of MsgA, the BS may transmit MsgB to the UE. MsgB may include an RAR for the UE.

An RRC connection request-related message (e.g., RRCSetupRequest message) requesting establishment of a connection between the RRC layer of the BS and the RRC layer of the UE may be included in the payload of MsgA. In this case, MsgB may be used to transmit RRC connection-related information (e.g., RRCSetup message). In contrast, the RRC connection request-related message (e.g., RRCSetupRequest message) may be transmitted on a PUSCH based on a UL grant in MsgB. In this case, RRC connection-related information (e.g., RRCSetup message) related to the RRC connection request may be transmitted on a PDSCH associated with the PUSCH transmission after the PUSCH transmission based on MsgB.

Upon successfully receiving MsgB associated with MsgA transmitted by the UE, the UE may transition to the RRC _CONNECTED state. When the UE is in the RRC _CONNECTED state, RRC messages may be exchanged between the RRC layer of the UE and the RRC layer of the BS. In other words, the UE in the RRC _CONNECTED state refers to the UE that establishes an RRC connection with the BS

A communication device on a receiving side may receive radio frequency (RF) signals at a carrier frequency through at least one antenna. In some implementations, the RF signals may include a signal related to a first bit sequence with a length of N. For example, a method or operations of the communication device may include: receiving a radio signal from another communication device over a physical channel on a serving cell of the communication device; obtaining an orthogonal frequency division multiplexing (OFDM) baseband signal by performing frequency downconversion on the received radio signal; obtaining complex-valued modulation symbols of the physical channel based on the OFDM baseband signal; and obtaining a first bit sequence with a length of N based on the complex-valued modulation symbols of the physical channel. The first bit sequence of length N may be decoded according to some implementations of the present disclosure.

The examples of the present disclosure as described above have been presented to enable any person of ordinary skill in the art to implement and practice the present disclosure. Although the present disclosure has been described with reference to the examples, those skilled in the art may make various modifications and variations in the example of the present disclosure. Thus, the present disclosure is not intended to be limited to the examples set for the herein, but is to be accorded the broadest scope consistent with the principles and features disclosed herein.

The implementations of the present disclosure may be used in a BS, a UE, or other equipment in a wireless communication system.

**Claims**

1. A method of decoding a received signal by a communication device in a wireless communication system, the method comprising:

    detecting a synchronization signal block (SSB) including a primary synchronization signal (PSS), a secondary synchronization signal (SSS), and a physical broadcast channel (PBCH);
    initiating a random access procedure including transmission of a physical random access channel (PRACH) based on the SSB;
    receiving a radio signal from another communication device over a physical channel on a serving cell of the communication device, based on the random access procedure;
    obtaining an orthogonal frequency division multiplexing (OFDM) baseband signal by performing frequency downconversion on the received radio signal;
    obtaining complex-valued modulation symbols of the physical channel based on the OFDM baseband signal;
    obtaining a first bit sequence with a length of N based on the complex-valued modulation symbols of the physical channel, where N is an integer greater than 1;
    determining P different shift parameters for the first bit sequence, where P is an integer greater than 1;
    generating P second bit sequences by cyclically shifting the first bit sequence based on the P different shift parameters; and
    determining a codeword by performing successive cancellation decoding with a list size of L on each of the P second bit sequences, where L is an integer greater than 0,
    wherein determining the P different shift parameters for the first bit sequence comprises determining a shift parameter s satisfying the following:

        an index i of a vulnerable bit among N bits of the first bit sequence is determined;
        operation values for the first bit sequence are grouped into a plurality of groups based on the index i of the vulnerable bit; and
        a predefined metric for the plurality of groups exceeds a predetermined threshold, wherein the predefined metric is obtained by summing differences between largest and smallest operation values for each of the plurality of groups.

2. The method of claim 1, wherein grouping the operation values into the plurality of groups based on the index i of the vulnerable bit comprises:

    based on a binary representation of the index i of the vulnerable bit, $(b\_1, b\_2, ..., b\_(n-1))$, determining to apply a boxplus operation for $b\_j = 0$ and to apply a summation operation for $b\_j = 1$; and
    determining indices of operation values combined by the boxplus operation among the operation values as one group.

3. The method of claim 1, wherein the first bit sequence includes bits obtained by the other communication device by encoding information bits with a length of K with an error correction code with a size of N.

4. The method of claim 1, further comprising:

determining combinations of candidates for a number of permutation paths and candidate list sizes based on a predetermined complexity for a parallelism of N/2; and
determining a combination with optimal performance based on decoding performance of each of the combinations,
wherein a candidate for the number of permutation paths and a candidate list size of the combination with the optimal performance are used as P and L, respectively.

5. A communication device configured to decode a received signal in a wireless communication system, the communication device comprising:

at least one transceiver;
at least one processor; and
at least one computer memory operably connected to the at least one processor and storing instructions that, when executed, cause the at least one processor to perform operations comprising:

detecting a synchronization signal block (SSB) including a primary synchronization signal (PSS), a secondary synchronization signal (SSS), and a physical broadcast channel (PBCH);
initiating a random access procedure including transmission of a physical random access channel (PRACH) based on the SSB;
receiving a radio signal from another communication device over a physical channel on a serving cell of the communication device, based on the random access procedure;
obtaining an orthogonal frequency division multiplexing (OFDM) baseband signal by performing frequency downconversion on the received radio signal;
obtaining complex-valued modulation symbols of the physical channel based on the OFDM baseband signal;
obtaining a first bit sequence with a length of N based on the complex-valued modulation symbols of the physical channel, where N is an integer greater than 1;
determining P different shift parameters for the encoded bit sequence, where P is an integer greater than 1;
generating P second bit sequences by cyclically shifting the encoded bit sequence based on the P different shift parameters; and
determining a codeword by performing successive cancellation decoding with a list size of L on each of the P second bit sequences, where L is an integer greater than 0,
wherein determining the P different shift parameters for the first bit sequence comprises determining a shift parameter s satisfying the following:

an index i of a vulnerable bit among N bits of the first bit sequence is determined;
operation values for the first bit sequence are grouped into a plurality of groups based on the index i of the vulnerable bit; and
a predefined metric for the plurality of groups exceeds a predetermined threshold, wherein the predefined metric is obtained by summing differences between largest and smallest operation values for each of the plurality of groups.

6. The communication device of claim 5, wherein grouping the operation values into the plurality of groups based on the index i of the vulnerable bit comprises:

based on a binary representation of the index i of the vulnerable bit, $(b\_1, b\_2, ..., b\_(n-1))$, determining to apply a boxplus operation for $b\_j = 0$ and to apply a summation operation for $b\_j = 1$; and
determining indices of operation values combined by the boxplus operation among the operation values as one group.

7. The communication device of claim 5, wherein the first bit sequence includes bits obtained by the other communication device by encoding information bits with a length of K with an error correction code with a size of N.

8. The communication device of claim 5, wherein the operations comprise:

determining combinations of candidates for a number of permutation paths and candidate list sizes based on a predetermined complexity for a parallelism of N/2; and

determining a combination with optimal performance based on decoding performance of each of the combinations,

wherein a candidate for the number of permutation paths and a candidate list size of the combination with the optimal performance are used as P and L, respectively.

9. A processing device in a wireless communication system, the processing device comprising:

at least one processor; and
at least one computer memory operably connected to the at least one processor and storing instructions that, when executed, cause the at least one processor to perform operations comprising:

detecting a synchronization signal block (SSB) including a primary synchronization signal (PSS), a secondary synchronization signal (SSS), and a physical broadcast channel (PBCH);
initiating a random access procedure including transmission of a physical random access channel (PRACH) based on the SSB;
receiving a radio signal from another communication device over a physical channel on a serving cell of the communication device, based on the random access procedure;
obtaining an orthogonal frequency division multiplexing (OFDM) baseband signal by performing frequency downconversion on the received radio signal;
obtaining complex-valued modulation symbols of the physical channel based on the OFDM baseband signal;
obtaining a first bit sequence with a length of N based on the complex-valued modulation symbols of the physical channel, where N is an integer greater than 1;
determining P different shift parameters for the first bit sequence, where P is an integer greater than 1;
generating P second bit sequences by cyclically shifting the first bit sequence based on the P different shift parameters; and
determining a codeword by performing successive cancellation decoding with a list size of L on each of the P second bit sequences, where L is an integer greater than 0,
wherein determining the P different shift parameters for the first bit sequence comprises determining a shift parameter s satisfying the following:

an index i of a vulnerable bit among N bits of the first bit sequence is determined;
operation values for the first bit sequence are grouped into a plurality of groups based on the index i of the vulnerable bit; and
a predefined metric for the plurality of groups exceeds a predetermined threshold, wherein the predefined metric is obtained by summing differences between largest and smallest operation values for each of the plurality of groups.

10. A computer-readable storage medium configured to store at least one program code comprising instructions that, when executed, cause at least one processor to perform operations comprising:
a processing device in a wireless communication system, the processing device comprising:

at least one processor; and
at least one computer memory operably connected to the at least one processor and storing instructions that, when executed, cause the at least one processor to perform operations comprising:

detecting a synchronization signal block (SSB) including a primary synchronization signal (PSS), a secondary synchronization signal (SSS), and a physical broadcast channel (PBCH);
initiating a random access procedure including transmission of a physical random access channel (PRACH) based on the SSB;
receiving a radio signal from another communication device over a physical channel on a serving cell of the communication device, based on the random access procedure;
obtaining an orthogonal frequency division multiplexing (OFDM) baseband signal by performing frequency downconversion on the received radio signal;
obtaining complex-valued modulation symbols of the physical channel based on the OFDM baseband signal;
obtaining a first bit sequence with a length of N based on the complex-valued modulation symbols of the physical channel, where N is an integer greater than 1;

determining P different shift parameters for the first bit sequence, where P is an integer greater than 1;
generating P second bit sequences by cyclically shifting the first bit sequence based on the P different shift parameters; and
determining a codeword by performing successive cancellation decoding with a list size of L on each of the P second bit sequences, where L is an integer greater than 0,
wherein determining the P different shift parameters for the first bit sequence comprises determining a shift parameter s satisfying the following:

an index i of a vulnerable bit among N bits of the first bit sequence is determined;
operation values for the first bit sequence are grouped into a plurality of groups based on the index i of the vulnerable bit; and
a predefined metric for the plurality of groups exceeds a predetermined threshold, wherein the predefined metric is obtained by summing differences between largest and smallest operation values for each of the plurality of groups.

# FIG. 1

1

100e — Home Appliance

100f — IoT device

400 — AI server / device

100a — Robot

150a    150a    200    300    200    100d — Hand-held device

Network (5G)    150a

200    200    100c — XR device

200    150a    150a

100b-1 — Vehicle ⟷ Vehicle — 100b-2

150b

## FIG. 2

## FIG. 3

# FIG. 4

| ··· | One Frame (10 ms) | ··· |

| ··· | Half-Frame (5ms) | Half-Frame (5ms) | ··· |

| ··· | Subframe 0 (1ms) | ··· | Subframe 4 (1ms) | Subframe 5 (1ms) | ··· | Subframe 9 (1ms) | ··· |

Subframe (1ms)

| 15kHz | Slot (14 symbols) |

1ms

| 30kHz | Slot 0 (14 symbols) | Slot 1 |

500us

| 60kHz | Slot 0 (14 Slot) | Slot 1 | Slot 2 | Slot 3 |

250us

| 120kHz | Slot 0 (14 symbols) | Slot 1 | Slot 2 | Slot 3 | Slot 4 | Slot 5 | Slot 6 | Slot 7 |

125us

# FIG. 5

Transport Block (TB)

```
         ○
         │
         ▼
┌───────────────────────┐
│   TB CRC Attachment    │
└───────────────────────┘
         │
         ▼
┌───────────────────────┐
│    Code Block (CB)     │
│     Segmentation       │
└───────────────────────┘
         │
         ▼
┌───────────────────────┐
│   CB CRC Attachment    │
└───────────────────────┘
         │
         ▼
┌───────────────────────┐
│    Channel Coding      │
└───────────────────────┘
         │
         ▼
┌───────────────────────┐
│     Rate Matching      │
└───────────────────────┘
         │
         ▼
┌───────────────────────┐
│   CBs Concatenation    │
└───────────────────────┘
         │
         ▼
         ○
```

# FIG. 6

$$F = \begin{bmatrix} 1 & 0 \\ 1 & 1 \end{bmatrix}$$

(a)                                    (b)

# FIG. 7

Original channels
(uniform)

New channels
(polarized)

W

W₁

Vector
channel

W_vec

⋮

⋮

W

W_{N-1}

W

W_N

Combine

Split

(a)

(b)

# FIG. 8

**FIG. 9**

**FIG. 10**

$$x_1 = \sum_{i=1}^{8} u_i$$

$x_2 = u_2 \oplus u_4 \oplus u_6 \oplus u_8$

$x_3 = u_3 \oplus u_4 \oplus u_7 \oplus u_8$

$x_4 = u_4 \oplus u_8$

$x_5 = u_5 \oplus u_6 \oplus u_7 \oplus u_8$

$x_6 = u_6 \oplus u_8$

$x_7 = u_7 \oplus u_8$

$x_8 = u_8$

$y_1$, $y_2$, $y_3$, $y_4$, $y_5$, $y_6$, $y_7$, $y_8$

W, W, W, W, W, W, W, W

$x_1$, $x_2$, $x_3$, $x_4$, $x_5$, $x_6$, $x_7$, $x_8$

$u_1$, $u_2$, $u_3$, $u_4$, $u_5$, $u_6$, $u_7$, $u_8$

| $C(W_i)$ | Rank | | |
|---|---|---|---|
| 0.0039 | 8 | frozen | |
| 0.1211 | 7 | frozen | |
| 0.1914 | 6 | frozen | |
| 0.6836 | 5 | data | |
| 0.3164 | 4 | frozen | |
| 0.8086 | 3 | data | |
| 0.8789 | 2 | data | |
| 0.9961 | 1 | data | |

# FIG. 11

# FIG. 12

$$\mathbf{c}^{(s)} = \sigma^s([c_1, c_2, c_3, \ldots, c_N])$$
$$= [c_{N-s+1}, c_{N-s+2}, \ldots, c_N, c_1, c_2, \ldots, c_{N-s}]$$

$$\hat{c} = \operatorname*{argmin}_{\hat{\mathbf{c}}^{(i)}} \left\| \mathbf{y} - \hat{\mathbf{c}}^{(i)} \right\|$$

$\hat{\mathbf{c}}$

$\hat{c}^{(1)}$   $\pi_1^{-1}$   $\hat{c}'^{(1)}$   SC Decoding   $\mathbf{y}^{(1)}$   $\pi_1$

$\hat{c}^{(2)}$   $\pi_2^{-1}$   $\hat{c}'^{(2)}$   SC Decoding   $\mathbf{y}^{(2)}$   $\pi_1$

$\mathbf{y}$

$\hat{c}^{(P)}$   $\pi_P^{-1}$   $\hat{c}'^{(P)}$   SC Decoding   $\mathbf{y}^{(P)}$   $\pi_P$

## FIG. 13

## FIG. 14

# FIG. 15

**Example) N = 64 and i = 7, binary representation (111000)**

➢ Search for consecutive 0s starting from MSB in binary representation (111000) : (111**000**)

➢ Substitute all possible binary vectors into positions of searched consecutive 0s

$$\begin{bmatrix} -- -000 \\ -- -100 \\ \vdots \\ -- -111 \end{bmatrix}$$

➢ Create partitioning for all possible binary vectors for remaining parts

$$\begin{bmatrix} 000000 \\ 000100 \\ \vdots \\ 000111 \end{bmatrix} \begin{matrix} 0 \\ 8 \\ \vdots \\ 56 \end{matrix} \quad \begin{bmatrix} 100000 \\ 100100 \\ \vdots \\ 100111 \end{bmatrix} \begin{matrix} 1 \\ 9 \\ \vdots \\ 57 \end{matrix} \cdots \begin{bmatrix} 111000 \\ 111100 \\ \vdots \\ 111111 \end{bmatrix} \begin{matrix} 7 \\ 15 \\ \vdots \\ 63 \end{matrix}$$

Partition      Partition      Partition

➢ Channel inputs belonging to same partition are involved in boxplus operation (⊞) during decoding process

$$L_N^{(i)} = g \begin{pmatrix} L_0 \boxplus L_8 \boxplus \cdots L_{56}, \\ L_1 \boxplus L_9 \boxplus \cdots L_{57}, \\ \vdots \\ L_7 \boxplus L_{15} \boxplus \cdots L_{63} \end{pmatrix}$$

# FIG. 16

**FIG. 17**

**FIG. 18**

EP 4 648 317 A1

**FIG. 19**

$$\mathbf{c}^{(s)} = \sigma^s([c_1, c_2, c_3, \dots, c_N])$$
$$= [c_{N-s+1}, c_{N-s+2}, \dots, c_N, c_1, c_2, \dots, c_{N-s}]$$

## FIG. 20

## FIG. 21

**FIG. 22**

# FIG. 23

Initial
Cell Search

System
Information
Reception

Random Access Procedure

General DL/UL Tx/Rx

**PSS/SSS & [DL RS] & PBCH**

**PDCCH/ PDSCH (BCCH)**

**PRACH**

**PDCCH/ PDSCH**

**PUSCH**

**PDCCH/ PDSCH**

**PDCCH/ PDSCH**

**PUSCH/ PUCCH**

S11

S12

S13

S14

S15

S16

S17

S18

- DL/UL HARQ-ACK
- UE CSI report via PUSCH and/or PUCCH

EP 4 648 317 A1

# FIG. 24

UE                                           BS

Msg1 on PRACH: preamble

Msg2 on PDSCH: random access response
(resource allocation)

Msg3 on PUSCH: scheduled transmission
(RRC Connection Request)

Msg4 on PDSCH: contention resolution
(RRC Connection Setup)

(a)

UE                                           BS

MsgA: preamble + payload

MsgB: random access response
(resource allocation)

(b)

# EP 4 648 317 A1

## INTERNATIONAL SEARCH REPORT

<table>
<tr><td colspan="2"></td><td>International application No.<br>**PCT/KR2023/000283**</td></tr>
</table>

**A. CLASSIFICATION OF SUBJECT MATTER**

**H04L 1/00**(2006.01)i; **H04W 74/08**(2009.01)i; **H03M 13/39**(2006.01)i; **H03M 13/43**(2006.01)i

According to International Patent Classification (IPC) or to both national classification and IPC

**B. FIELDS SEARCHED**

Minimum documentation searched (classification system followed by classification symbols)

H04L 1/00(2006.01); H03M 13/09(2006.01); H04L 5/00(2006.01); H04W 74/08(2009.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 로그 가능성 비율(log likelihood ratio, LLR), 디코딩(decoding), 1차 동기 신호 (primary synchronization signal, PSS), 2차 동기 신호(secondary synchronization signal, SSS), 물리 방송 채널(physical broadcast channel, PBCH), 동기 신호 블록(synchronization signal block, SSB), 물리 임의 접속 채널(physical random access channel, PRACH), 직교 주파수 분할 다중화(orthogonal frequency division multiplexing, OFDM), 변조 심볼(modulation symbol), 비트 시퀀스(bit sequence), 쉬프트 파라미터(shift parameter), 취약 비트(weakness bit), 연속 소거(successive cancellation, SC), 그룹(group), 메트릭(metric)

**C. DOCUMENTS CONSIDERED TO BE RELEVANT**

| Category* | Citation of document, with indication, where appropriate, of the relevant passages | Relevant to claim No. |
|---|---|---|
| A | WO 2022-042473 A1 (ZTE CORPORATION) 03 March 2022 (2022-03-03)<br>See pages 3-8; claim 1; and figure 2. | 1-10 |
| A | KR 10-2021-0067967 A (SAMSUNG ELECTRONICS CO., LTD.) 08 June 2021 (2021-06-08)<br>See paragraphs [0041]-[0066]; and claims 1-7. | 1-10 |
| A | KR 10-2293600 B1 (AJOU UNIVERSITY INDUSTRY-ACADEMIC COOPERATION FOUNDATION) 24 August 2021 (2021-08-24)<br>See claims 1-5. | 1-10 |
| A | KR 10-2021-0112373 A (VIVO MOBILE COMMUNICATION CO., LTD.) 14 September 2021 (2021-09-14)<br>See paragraph [0017]; and claims 1-12. | 1-10 |

☑ Further documents are listed in the continuation of Box C.      ☑ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **22 September 2023** | **22 September 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| :--- |
| **PCT/KR2023/000283** |

**C. DOCUMENTS CONSIDERED TO BE RELEVANT**

| Category* | Citation of document, with indication, where appropriate, of the relevant passages | Relevant to claim No. |
| :---: | :--- | :---: |
| A | ABDULWAHAB, Walled Khalid et al. Reduced Path Successive Cancellation List Decoding for Polar Codes. International Journal of Engineering and Technology Innovation. vol. 11, no. 1, 2021. See sections 1-2. | 1-10 |

Form PCT/ISA/210 (second sheet) (July 2022)

**INTERNATIONAL SEARCH REPORT**
Information on patent family members

International application No.

**PCT/KR2023/000283**

| Patent document cited in search report | | | Publication date (day/month/year) | Patent family member(s) | | | Publication date (day/month/year) |
|---|---|---|---|---|---|---|---|
| WO | 2022-042473 | A1 | 03 March 2022 | CN | 114095118 | A | 25 February 2022 |
| | | | | EP | 4195545 | A1 | 14 June 2023 |
| | | | | JP | 2023-527392 | A | 28 June 2023 |
| | | | | KR | 10-2023-0012598 | A | 26 January 2023 |
| | | | | US | 2023-0275690 | A1 | 31 August 2023 |
| KR | 10-2021-0067967 | A | 08 June 2021 | CN | 115023900 | A | 06 September 2022 |
| | | | | EP | 4050805 | A1 | 31 August 2022 |
| | | | | US | 2022-0278772 | A1 | 01 September 2022 |
| | | | | WO | 2021-107746 | A1 | 03 June 2021 |
| KR | 10-2293600 | B1 | 24 August 2021 | KR | 10-2293600 | B9 | 17 September 2021 |
| | | | | US | 11483012 | B2 | 25 October 2022 |
| | | | | US | 2021-0288664 | A1 | 16 September 2021 |
| KR | 10-2021-0112373 | A | 14 September 2021 | CN | 111182648 | A | 19 May 2020 |
| | | | | CN | 111182648 | B | 17 May 2022 |
| | | | | EP | 3914025 | A1 | 24 November 2021 |
| | | | | JP | 2022-517657 | A | 09 March 2022 |
| | | | | JP | 7241186 | B2 | 16 March 2023 |
| | | | | SG | 11202107840 | A | 30 August 2021 |
| | | | | US | 2021-0345427 | A1 | 04 November 2021 |
| | | | | WO | 2020-147816 | A1 | 23 July 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. ARIKAN**. Channel Polarization: A Method for Constructing Capacity-Achieving Codes for Symmetric Binary-Input Memoryless Channels. *IEEE Transactions on Information Theory*, July 2009, vol. 55 (7), 3051-3073
- **I. TAL** ; **A. VARDY**. List decoding of polar codes. *Proc. IEEE Int. Symp. Inf. Theory*, July 2011, 1-5
- **BALATSOUKAS-STIMMING** ; **M. BASTANI PARIZI** ; **A. BURG**. On metric sorting for successive cancellation list decoding of polar codes. *IEEE International Symposium on Circuits and Systems (ISCAS)*, 2015, 1993-1996
- **S. A. HASHEMI** ; **A. BALATSOUKAS-STIMMING** ; **P. GIARD, C. THIBEAULT** ; **W. J. GROSS**. Partitioned successive-cancellation list decoding of polar codes. *IEEE International Conference on Acoustics, Speech and Signal Processing (ICASSP)*, 2016, 957-960
- **K. LEE** ; **I. PARK**. Large-Small Sorting for Successive Cancellation List Decoding of Polar Codes. *IEEE Access*, 2020, vol. 8, 96955-96962